# EUROPÄISCHE PATENTSCHRIFT

(11) **EP 4 204 740 B1**
(45) Veröffentlichungstag und Bekanntmachung des Hinweises auf die Patenterteilung: **02.10.2024**
(21) Anmeldenummer: 21765946.5
(22) Anmeldetag: 26.08.2021
(51) Int. Cl.: F24D 19/10, H04L 12/403, F24H 4/00

(54) **SYSTEM UND VERFAHREN ZUM STEUERN EINER WÄRMEPUMPE**
SYSTEM AND METHOD FOR CONTROLLING A HEAT PUMP
SYSTÈME ET PROCÉDÉ DE COMMANDE D'UNE POMPE À CHALEUR

(30) Priorität: 27.08.2020 EP 20193167
(43) Veröffentlichungstag der Anmeldung: 05.07.2023
(73) Patentinhaber: Fronius International GmbH, 4643 Pettenbach (AT)
(72) Erfinder: BRANDSTÖTTER, Markus, 4643 Pettenbach (AT); MÜHLEGGER, Johannes, 4643 Pettenbach (AT)
(74) Vertreter: Bratovic, Nino Maria
(86) Internationale Anmeldenummer: PCT/EP2021/073591
(87) Internationale Veröffentlichungsnummer: WO 2022/043426

(56) Entgegenhaltungen:
- EP-A1- 1 978 715
- DE-A1- 102008 019 053
- DE-A1- 102017 203 249
- DE-A1- 102017 220 414

## Beschreibung

Die Erfindung betrifft ein System, insbesondere ein Energiemanagementsystem eines Energiesystems, und ein Verfahren zum Steuern einer Wärmepumpe, die in das Energiemanagementsystem des Energiesystems eingebunden ist.

Dokumente, die sich mit Energiemanagment in diesem Sinne beschäftigen sind: DE 10 2017 220414 A1 (BOSCH GMBH ROBERT [DE]) 16. Mai 2019 (2019-05-16); DE 10 2008 019053 A1 (ENDRESS & HAUSER PROCESS SOLUT [CH]) 22. Oktober 2009 (2009-10-22); DE 10 2017 203249 A1 (VIESSMANN WERKE KG [DE]) 30. August 2018 (2018-08-30); EP 1 978 715 A1 (KOPF DANIEL [AT]) 8. Oktober 2008 (2008-10-08) Energiesysteme, insbesondere Photovoltaikanlagen, lassen sich mit Wärmepumpen kombinieren. Eine Photovoltaikanlage liefert Solarstrom, welchen die Wärmepumpe des Energiesystems in Wärme umwandeln kann. Diese umgewandelte Wärme kann in einem Warmwasser- oder Pufferspeicher des Energiesystems gespeichert werden. Die Temperaturen des Speichermediums können im Tagesverlauf während der Solarstromproduktion angehoben werden. In den Abendstunden können Heizwärme- und Warmwasserbedarf zunächst aus dem Warmwasser- und Pufferspeicher gedeckt werden. Eine Wärmepumpe entzieht während des Betriebes der Umwelt, d.h. Luft, Erde oder Grundwasser, Wärme und führt sie dem lokalen Energiesystem zu. Durch Kombination einer Wärmepumpe mit einer Photovoltaikanlage kann der lokal produzierte Photovoltaikstrom für die Wärmepumpe genutzt werden. Die Photovoltaikanlage liefert Solarstrom für die Wärmepumpe, sodass insbesondere die Heizkosten gesenkt werden können. Ferner steigert die Wärmepumpe durch die erhöhte Abnahme des lokal produzierten Photovoltaikstroms die Effizienz der Photovoltaikanlage. Die Wärmepumpe kann eine Verdampfungseinheit, eine Verdichtungseinheit, eine Kondensatoreinheit und eine Entspannungseinheit aufweisen und in einem Kreisprozess betrieben werden. Die Photovoltaikanlage umfasst mehrere Solarmodule sowie einen oder mehrere Wechselrichter, welche den von den Solarmodulen erzeugten elektrischen Gleichstrom in eine Wechselspannung umwandeln. Diese generierte Wechselspannung kann zum Betrieb mindestens einer Wärmepumpe herangezogen werden. Herkömmliche Wärmepumpen können allerdings in unterschiedlicher Weise angesteuert werden und somit unterschiedliche Steuerungstypen aufweisen. Bei herkömmlichen Energiesystemen ist es daher äußerst schwierig, Wärmepumpen unterschiedlicher Hersteller und/oder unterschiedlichen Steuerungstyps in das Energiesystem bzw. das Energiemanagementsystem zu integrieren bzw. einzubinden. Darüber hinaus ist es kaum möglich, eine implementierte Wärmepumpe eines bestimmten Steuerungstyps und/oder eines bestimmten Herstellers durch eine andersartige Wärmepumpe eines anderen Herstellers und/oder anderen Steuerungstyps zu ersetzen.

In vielen Fällen soll ein Energiemanagementsystem in einem bestehenden Energiesystem mit einer bereits vorhandenen Wärmepumpe eingeführt werden. Ein Energiemanagementsystem kann beispielsweise mit einem modernen Photovoltaik-Wechselrichter, der über eine Systemsteuerung mit den erforderlichen Fähigkeiten für ein Energiemanagement verfügt, gebildet werden. Dabei scheitert eine vollständige Einbindung der Wärmepumpe in das Energiemanagementsystem oft an der Kompatibilität zu der bereits vorhandenen Wärmepumpe. Obwohl sich ein simples Ein- bzw. Ausschalten der Wärmepumpe in manchen Fällen von einem Energiemanagementsystem durchführen lässt, ist damit kein effizientes Energiemanagement zu erzielen und das harte Ein- und Ausschalten kann die Komponenten der Wärmepumpe unnötig belasten und so deren Lebensdauer verkürzen.

Aus dem Stand der Technik sind Energiemanagementsysteme bekannt, die ebenfalls Wärmepumpen in Abhängigkeit von der Verfügbarkeit einer Energiequelle ansteuern. Die Implementierung unterscheidet sich hinsichtlich der Art der Integration der Wärmepumpe. Dabei ist ein bestimmter Steuerungstyp einer Wärmepumpe nativ in den Source Code des Energiemanagements integriert, jedoch nicht über eine Wärmepumpen-Konfigurationsdatei. Das hat den Nachteil, dass für die Implementierung einer anderen Wärmepumpe der Source Code angepasst werden muss. Der Aufwand dafür ist erheblich und für den Betreiber in der Regel nicht möglich. Eine eingeschränkte Kompatibilität mit Wärmepumpen ist die Folge.

Aus dem Stand der Technik ist ferner ein Energiemanagement für Gebäude bekannt, welches über verschiedene Protokolle, wie z.B. MODBUS, Register auslesen und schreiben kann. Dabei hat der Nutzer die Möglichkeit, die Register über ein Tool zu konfigurieren. Mit der Möglichkeit des Auslesens und Schreibens von Registern der Wärmepumpe wird die gezielte Nutzung von Energiequellen, wie z.B. die Erhöhung des Eigenverbrauchs, nicht erreicht.

Es ist daher eine Aufgabe der vorliegenden Erfindung, ein Energiesystem zu schaffen, welches erlaubt, unterschiedliche Wärmepumpen, insbesondere Wärmepumpen unterschiedlichen Steuerungstyps, flexibel in das Energiesystem und dessen Energiemanagement einzubinden, sodass ein Austausch oder ein Upgrade einer Wärmepumpe innerhalb des Energiesystems erleichtert wird.

Eine weitere Aufgabe der vorliegenden Erfindung besteht darin, dass ein zumindest eine Wärmepumpe umfassendes Energiesystem mit einem Wechselrichter, umfassend ein Energiemanagementsystem, erweitert werden kann, wobei die Anbindung von Wärmepumpen verschiedener Steuerungstypen an den Wechselrichter bzw. sein Energiemanagementsystem auf einfache Weise ermöglicht wird.

Diese Aufgabe wird erfindungsgemäß durch ein Energiesystem mit den in Patentanspruch 1 angegebenen Merkmalen gelöst.

Die Erfindung schafft demnach ein Energiesystem mit einem Wechselrichter zur Umwandlung einer elektrischen Gleichspannung in eine Wechselspannung, die zur Versorgung elektrischer Verbrauchseinheiten des Energiesystems nutzbar und durch mindestens eine Wärmepumpe des Energiesystems in Wärme umwandelbar ist,
wobei die Wärmepumpe durch eine Systemsteuerung des Energiesystems über eine Steuerungsschnittstelle entsprechend einer in einem Datenspeicher der Systemsteuerung geladenen Wärmepumpen-Konfigurationsdatei steuerbar ist, wobei eine Kommunikation mit einer für die Wärmepumpe vorgesehenen Wärmepumpensteuerung entsprechend einem in der Wärmepumpen-Konfigurationsdatei angegebenen Steuerungstyp der Wärmepumpe erfolgt, wobei die Wärmepumpe mehrere Steuerungstypen aus einer vorgegebenen Gruppe von Steuerungstypen unterstützt, wobei die Gruppe von Steuerungstypen die folgenden Steuerungstypen umfasst:
einen ersten Steuerungstyp (I) bei dem die Wärmepumpe durch Leistungsvorgabe steuerbar ist,
einen zweiten Steuerungstyp (II) bei dem die Wärmepumpe durch Temperaturvorgabe steuerbar ist,
einen dritten Steuerungstyp (III) bei dem die Wärmepumpe durch eine SG-Ready-Vorgabe steuerbar ist, und einenvierten Steuerungstyp (IV) bei dem die Wärmepumpe durch Simulation oder Emulation eines Wärmepumpen-Stromzählers steuerbar ist.

Die Wärmepumpen-Konfigurationsdatei beschreibt neben der Konfiguration der Register mögliche Varianten der Ansteuerung der Wärmepumpe, sodass ein Kunde keinen Fachmann für die Konfiguration der Register und der Programmierung der Wärmepumpensteuerung benötigt.

Bei einer möglichen Ausführungsform umfasst das Energiesystem eine Photovoltaikanlage mit Solarmodulen, welche eine Gleichspannung generieren, die durch den Wechselrichter in eine Wechselspannung umgewandelt wird.

Bei einer weiteren möglichen Ausführungsform des erfindungsgemäßen Energiesystems umfasst der Steuerungstyp der Wärmepumpe einen von vier vorgegebenen Steuerungstypen.

Bei einem ersten Steuerungstyp ist die Wärmepumpe durch Leistungsvorgabe steuerbar.

Bei einem weiteren Steuerungstyp ist die Wärmepumpe durch Temperaturvorgabe steuerbar.

Bei einem dritten Steuerungstyp ist die Wärmepumpe durch eine SG-Ready-Vorgabe steuerbar.

Bei einem vierten Steuerungstyp ist die Wärmepumpe durch eine von der Systemsteuerung simulierte oder emulierte Wärmepumpen-Strommesseinheit des Energiesystems steuerbar.

Bei einer möglichen Ausführungsform des erfindungsgemäßen Energiesystems gibt zumindest ein in der Wärmepumpen-Konfigurationsdatei angegebener Parameter ein Kommunikationsprotokoll zur Kommunikation der Systemsteuerung mit der Wärmepumpensteuerung an.

Bei einer möglichen Ausführungsform des erfindungsgemäßen Energiesystems weist das in der Wärmepumpen-Konfigurationsdatei angegebene Kommunikationsprotokoll ein MODBUS-Kommunikationsprotokoll, insbesondere ein MODBUS-TCP-Kommunikationsprotokoll oder ein MODBUS-RTU-Kommunikationsprotokoll, auf.

Bei einer weiteren möglichen Ausführungsform des erfindungsgemäßen Energiesystems kommuniziert die Systemsteuerung des Energiemanagementsystems mit der Wärmepumpensteuerung über die Steuerungsschnittstelle und einen Bus des Energiesystems entsprechend dem in der Wärmepumpen-Konfigurationsdatei angegebenen Kommunikationsprotokoll. Dabei erfolgt die Kommunikation vorzugsweise bidirektional.

Bei einer weiteren möglichen Ausführungsform des erfindungsgemäßen Energiesystems wird die Systemsteuerung des Energiesystems in Abhängigkeit von dem in der Wärmepumpen-Konfigurationsdatei angegebenen Steuerungstyp automatisch als Mastergerät oder als Slavegerät konfiguriert.

Bei einer weiteren möglichen Ausführungsform des erfindungsgemäßen Energiesystems beinhaltet die Wärmepumpen-Konfigurationsdatei der Wärmepumpe eine Netzwerkadresse der Wärmepumpensteuerung zur Kommunikation mit der Systemsteuerung des Energiesystems entsprechend dem in der Wärmepumpen-Konfigurationsdatei der Wärmepumpe angegebenen Datenpunkt-Informationen .

Bei einer möglichen Ausführungsform des erfindungsgemäßen Energiesystems weist die Wärmepumpen-Konfigurationsdatei der Wärmepumpe eine JSON-, XML-, CSV- oder TXT-Datei auf.

Bei einer weiteren möglichen Ausführungsform des erfindungsgemäßen Energiesystems ist die Systemsteuerung in dem Wechselrichter des Energiesystems integriert.

Bei einer weiteren möglichen Ausführungsform des erfindungsgemäßen Energiesystems ist das Energiesystem an ein Stromversorgungsnetz über eine Strommesseinheit angeschlossen, welche Messdaten an die Systemsteuerung bzw. das Energiemanagementsystem des Energiesystems liefert.

Beim erfindungsgemäßen Energiesystem beinhaltet die Wärmepumpen-Konfigurationsdatei konfigurierbare Betriebsparameter zur Parametrisierung des Steuerungstyps und/oder der Wärmepumpe.

Bei einer weiteren möglichen Ausführungsform des erfindungsgemäßen Energiesystems ist die Wärmepumpen-Konfigurationsdatei über eine Nutzerschnittstelle der Systemsteuerung bzw. des Energiemanagementsystems auswählbar und editierbar.

Bei einer weiteren möglichen Ausführungsform des erfindungsgemäßen Energiesystems wird die Wärmepumpen-Konfigurationsdatei von einem Webserver einer Cloud-Plattform über ein Datennetzwerk in den lokalen Datenspeicher der Systemsteuerung des Energiesystems geladen.

Bei einer weiteren möglichen Ausführungsform des erfindungsgemäßen Energiesystems wird die Wärmepumpen-Konfigurationsdatei durch eine Leseeinheit der Systemsteuerung aus einem Datenträger in den lokalen Datenspeicher der Systemsteuerung des Energiesystems geladen.

Bei einer weiteren möglichen Ausführungsform des erfindungsgemäßen Energiesystems erhält der Wechselrichter die elektrische Gleichspannung von einem Photovoltaikmodul und wandelt diese in eine Wechselspannung um.

Bei einer weiteren möglichen Ausführungsform des erfindungsgemäßen Energiesystems weist die Wärmepumpensteuerung einen lokalen Datenspeicher zur Abspeicherung einer oder mehrerer zugehöriger Wärmepumpen-Konfigurationsdateien auf, die von der Systemsteuerung des Energiesystems über den Bus des Energiesystems während eines Initialisierungsvorganges des Energiesystems auslesbar und in den Datenspeicher der Systemsteuerung speicherbar ist.

Bei einer weiteren möglichen Ausführungsform des erfindungsgemäßen Energiesystems ist die Wärmepumpensteuerung der Wärmepumpe in der Wärmepumpe integriert.

Bei einer alternativen Ausführungsform ist die Wärmepumpensteuerung der Wärmepumpe außerhalb der Wärmepumpe und über eine Schnittstelle mit der Wärmepumpe verbunden.

Die Erfindung schafft gemäß einem weiteren Aspekt ein Verfahren zum Steuern einer Wärmepumpe.

Im Weiteren werden mögliche Ausführungsformen des erfindungsgemäßen Energiesystems und des erfindungsgemäßen Verfahrens zur Steuerung einer Wärmepumpe unter Bezugnahme auf die beigefügten Figuren näher erläutert.

Es zeigen:
- Fig. 1: ein Blockschaltbild zur Darstellung eines Ausführungsbeispiels eines erfindungsgemäßen Energiesystems;
- Fig. 2: ein Ablaufdiagramm zur Darstellung eines erfindungsgemäßen Initialisierungsvorganges des Energiemanagementsystems bzw. der Systemsteuerung;
- Fig. 3: ein weiteres Ablaufdiagramm zur Darstellung eines Ausführungsbeispiels des Verfahrens zur Steuerung einer Wärmepumpe des Energiesystems;
- Figuren 4A, 4B: tabellarisch ein Ausführungsbeispiel einer Wärmepumpen-Konfigurationsdatei;
- Fig. 5: aufbauend auf Wärmepumpen-Konfigurationsdatei aus Figuren 4A, 4B beispielhaft mögliche Einstellungen und Eingaben per Nutzerschnittstelle;
- Fig. 6: ein weiteres Blockschaltbild zur Darstellung eines Ausführungsbeispiels eines erfindungsgemäßen Energiesystems mit einer Wärmepumpe des Steuerungstyps IV und einem für diese simulierten Wärmepumpen-Smartmeter; und
- Fig. 7: ein Ablaufdiagramm zur Darstellung eines Ausführungsbeispiels des erfindungsgemäßen Verfahrens zum Steuern einer Wärmepumpe.

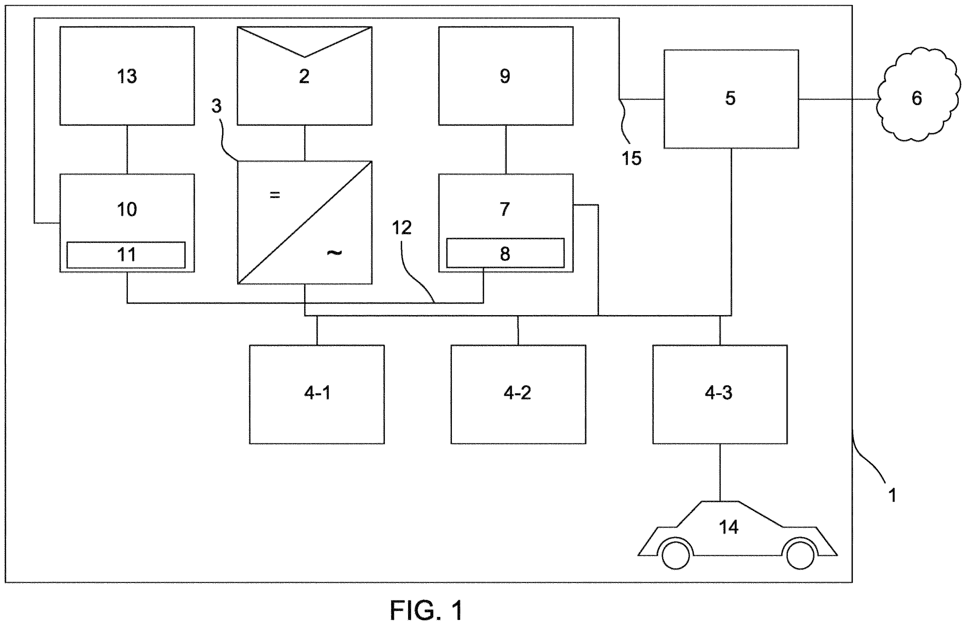

Wie man aus Fig. 1 erkennen kann, umfasst ein Energiesystem 1 mehrere Hauptkomponenten. Bei dem in Fig. 1 dargestellten Ausführungsbeispiel umfasst das Energiesystem 1 eine Photovoltaikanlage mit Photovoltaikmodulen 2, die einen Photovoltaikstrom liefern. Ein Wechselrichter 3 des Energiesystems 1 wandelt eine empfangene elektrische Gleichspannung bzw. Gleichstrom in eine Wechselspannung um. Diese Wechselspannung kann zur Versorgung elektrischer Verbrauchseinheiten 4 (4-1, 4-2, 4-3) des Energiesystems 1 genutzt werden. Bei den elektrischen Verbrauchseinheiten 4 kann es sich um unterschiedliche Einheiten handeln, die elektrische Energie verbrauchen. Bei den elektrischen Verbrauchseinheiten 4 handelt es sich beispielsweise um Haushaltsgeräte oder elektrische Pumpen. Weiterhin ist die in Fig. 1 dargestellte elektrische Verbrauchseinheit 4-3 geeignet, elektrische Speichereinheiten, insbesondere Batterien, an das Energiesystem 1 anzuschließen. Beispielsweise kann eine Fahrzeugbatterie eines Fahrzeuges 14 über die Einheit 4-3 (Wallbox) des Energiesystems 1 zum Aufladen angeschlossen werden. Das Energiesystem 1 verfügt ferner über eine Strommesseinheit 5. An das Energiesystem 1 ist über die Strommesseinheit 5 ein Stromversorgungsnetz 6 angeschlossen. Die Strommesseinheit 5 ist über eine Datenleitung 15 mit der Systemsteuerung 10 verbunden. Das Energiesystem 1 kann über die Strommesseinheit 5 elektrischen Strom in das Stromversorgungsnetz 6 einspeisen oder von dem Stromversorgungsnetz 6 beziehen. Das Energiesystem 1 weist mindestens eine Wärmepumpe 7 mit einer zugehörigen Wärmepumpensteuerung 8 auf. Die Wärmepumpensteuerung 8 kann bei einer möglichen Ausführungsform in der Wärmepumpe 7 integriert sein, wie in Fig. 1 dargestellt. Alternativ kann eine externe Wärmepumpensteuerung 8 über eine Schnittstelle an die Wärmepumpe 7 angeschlossen sein (nicht dargestellt). Die Wärmepumpe 7 ist vorzugsweise an einen Wärmespeicher 9 angeschlossen, welcher die von der Wärmepumpe 7 erzeugte Wärme zwischenspeichert. Der Wärmespeicher 9 kann dabei durch einen Pufferspeicher (Wassertank), eine Fußbodenheizung, den Wasserinhalt eines Pools oder dergleichen gebildet sein. Ebenso kann der Wärmespeicher 9 durch einen Kältespeicher gebildet sein. Die Wärmepumpe 7 kann auch an eine Kühleinrichtung angeschlossen werden (nicht dargestellt).

Das Energiesystem 1 verfügt über eine Systemsteuerung 10 mit einem Datenspeicher 11. Bei einer möglichen Ausführungsform kann der Datenspeicher 11 in der Systemsteuerung 10 integriert sein, wie in Fig. 1 dargestellt. Alternativ ist der Datenspeicher 11 über eine Datenschnittstelle oder ein lokales Datennetzwerk mit der Systemsteuerung 10 verbunden. Die Systemsteuerung 10 mit dem integrierten Datenspeicher 11 ist, wie in Fig. 1 dargestellt, über eine Steuerungsschnittstelle 12 mit der Wärmepumpensteuerung 8 der Wärmepumpe 7 verbunden. Die Wärmepumpe 7 ist durch die Systemsteuerung 10 des Energiesystems 1 über die Steuerungsschnittstelle 12 entsprechend einer in dem Datenspeicher 11 der Systemsteuerung 10 gespeicherten bzw. geladenen Wärmepumpen-Konfigurationsdatei steuerbar. Dabei erfolgt eine Kommunikation mit der für die Wärmepumpe 7 vorgesehenen Wärmepumpensteuerung 8 entsprechend einem in der Wärmepumpen-Konfigurationsdatei angegebenen Steuerungstyp der Wärmepumpe 7.

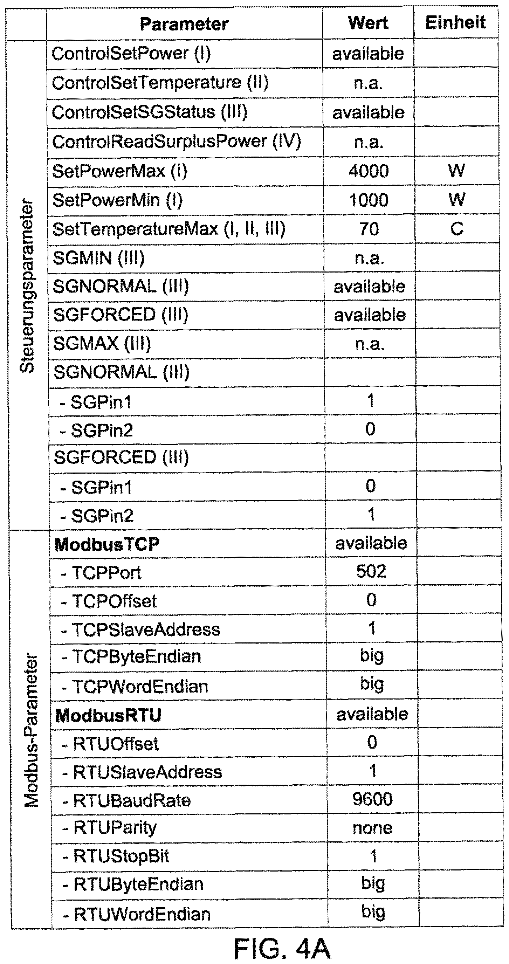

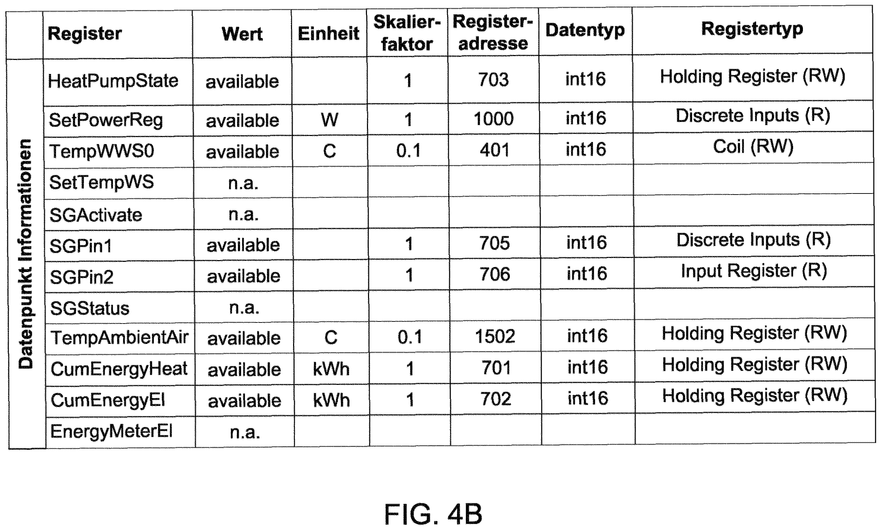

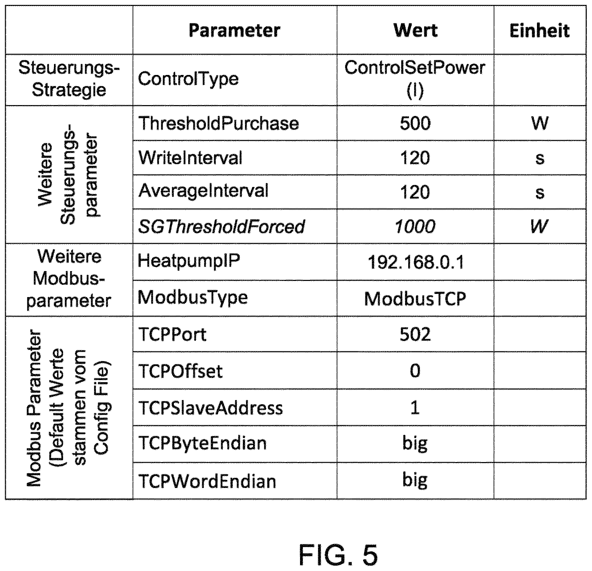

Eine Wärmepumpen-Konfigurationsdatei WPK (wie beispielhaft in Fig. 4A, 4B dargestellt) bildet vorzugsweise in weiterer Folge eine Auswahl von Parametern für weitere Nutzereingaben (wie beispielhaft in Fig. 5 dargestellt). Beispielsweise kann ein Nutzer einen MODBUS-Type, MODBUS-Parameter, weitere Verbindungsparameter, eine Steuerungsstrategie und weitere Steuerungsparameter über eine Nutzerschnittstelle 13 der Systemsteuerung 10 bzw. des Energiemanagementsystems eingeben oder auswählen, falls gemäß Wärmepumpen-Konfigurationsdatei mehrere Möglichkeiten zur Auswahl vorliegen. Bei der Nutzerschnittstelle 13 handelt es sich bevorzugt um eine Applikation, wie eine Website oder eine App, welche beispielsweise von einem festangebundenen Gerät oder von einem tragbaren Gerät gestartet bzw. aufgerufen werden kann, beispielsweise ein Tablet oder Mobilfunktelefon. Über die Nutzerschnittstelle 13 kann der Nutzer bzw. Betreiber des Energiesystems 1 bestimmte Einstellungen vornehmen.

Der Datenspeicher 11 des Energiesystems 1 dient zur lokalen Datenspeicherung der Wärmepumpen-Konfigurationsdatei WPK der Wärmepumpe 7. Bei einer möglichen Ausführungsform wird die Wärmepumpen-Konfigurationsdatei WPK von einem Webserver einer Cloud Plattform über ein Datennetzwerk in den lokalen Datenspeicher 11 der Systemsteuerung 10 des Energiesystems 1 geladen. Alternativ kann die Wärmepumpen-Konfigurationsdatei WPK auch durch eine Leseeinheit der Systemsteuerung 10 aus einem Datenträger in den lokalen Datenspeicher 11 der Systemsteuerung 10 des Energiesystems 1 geladen werden. Die Wärmepumpen-Konfigurationsdatei WPK der Wärmepumpe 7 kann bei einer möglichen Ausführungsform eine JSON-, XML-, CSV- oder TXT-Datei aufweisen. Bei einer möglichen Ausführungsform gibt zumindest ein in der Wärmepumpen-Konfigurationsdatei WPK angegebener Parameter ein Kommunikationsprotokoll zur Kommunikation der Systemsteuerung 10 mit der Wärmepumpensteuerung 8 an. Das in der Wärmepumpen-Konfigurationsdatei WPK angegebene Kommunikationsprotokoll weist bei einer möglichen Ausführungsform ein MODBUS-Kommunikationsprotokoll auf. Hierbei kann es sich um ein MODBUS-TCP-Kommunikationsprotokoll oder ein MODBUS-RTU-Kommunikationsprotokoll handeln. Die Steuerungsschnittstelle 12 zwischen der Systemsteuerung 10 des Energiesystems 1 und der Wärmepumpensteuerung 8 der Wärmepumpe 7 weist bei einer möglichen Ausführungsform einen Bus zur Übertragung von Steuersignalen und/oder Daten auf. Die Kommunikation zwischen der Systemsteuerung 10 und der Wärmepumpensteuerung 8 erfolgt bei einer möglichen Ausführungsform des erfindungsgemäßen Energiesystems 1 bidirektional, d.h. durch Austausch von Daten und Steuerungssignalen in beide Richtungen. Bei einer Ausführungsform kann die Kommunikation auch über eine Funkschnittstelle zwischen der Wärmepumpensteuerung 8 und der Systemsteuerung 10 erfolgen. Bei einer möglichen Ausführungsform wird die Systemsteuerung 10 des Energiesystems 1 in Abhängigkeit von dem in der Wärmepumpen-Konfigurationsdatei WPK angegebenen Steuerungstyp automatisch als Mastergerät oder als Slavegerät konfiguriert. Die Wärmepumpen-Konfigurationsdatei WPK der Wärmepumpe 7 beinhaltet bei einer möglichen Ausführungsform eine Netzwerkadresse der Wärmepumpensteuerung 8 zur Kommunikation mit der Systemsteuerung 10 des Energiesystems 1 entsprechend dem in der Wärmepumpen-Konfigurationsdatei WPK der Wärmepumpe 7 angegebenen Datenpunkt-Informationen. Die Wärmepumpen-Konfigurationsdatei WPK beinhaltet vorzugsweise konfigurierbare Betriebsparameter zur Parametrisierung des Steuerungstyps der Wärmepumpe und/oder der Wärmepumpe 7 selbst.

Fig. 4A, 4B zeigen tabellarisch ein Ausführungsbeispiel einer Wärmepumpen-Konfigurationsdatei WPK. Bei dem in den Figuren 4A, 4B dargestellten Ausführungsbeispiel der Wärmepumpen-Konfigurationsdatei WPK umfasst diese Steuerungsparameter, MODBUS-Parameter sowie Datenpunktinformationen.

In dem dargestellten Beispiel gemäß Fig. 4A ist eine Steuerung durch Leistungsvorgabe als Steuerungstyp I (ControlSetPower available) und eine Steuerung durch SG-Ready-Vorgabe als Steuerungstyp III (ControlSetSGStatus available) als Möglichkeit eingetragen. Die übrigen zwei Steuerungstypen II und IV werden von der betreffenden Wärmepumpensteuerung 8 nicht unterstützt und dürfen daher in weiterer Folge für eine Auswahl oder Anwendung nicht verfügbar sein. Damit dies sichergestellt ist, sind ControlSetTemperature und ControlReadSurplusPower in Fig. 4A auf nicht verfügbar ("n.a.") gesetzt.

Bei der Steuerung durch Leistungsvorgabe gemäß Steuerungstyp I wird z.B. ein Wert eines aktuellen bzw. eines momentan verfügbaren Anteils einer Überschussleistung eines Energiesystems 1 oder eines Stromversorgungsnetzes 6 in ein Register der Wärmepumpensteuerung 8 eingeschrieben. Im Beispiel in Fig. 4B entspricht dies dem Register "SetPowerReg" mit der Registeradresse 1000 und der Wert einer Überschussleistung wird von der Wärmepumpensteuerung 8 in der Einheit Watt als 16 Bit Integer "int16" übernommen. Im Fall, dass sowohl Energiemanagementsystem als auch Wärmepumpensteuerung die gleiche Einheit für einen Wert, z.B. Watt "W", verwenden, ist in der Wärmepumpen-Konfigurationsdatei in Fig. 4B der Skalierfaktor = 1 eingetragen. Mittels der Skalierfaktoren für die Register von Wärmepumpensteuerungen können unterschiedliche Einheiten von Werten zwischen beliebigen Wärmepumpensteuerungen 8 und dem Energiemanagementsystem des Energiesystems 1 auf einfache Weise in Einklang gebracht werden. Überschussleistung in einem Energiesystem 1 entsteht oft durch eine den Verbrauch übersteigende Erzeugungsleistung des Wechselrichters 3. Um die Effizienz einer PV-Anlage zu erhöhen, wird in der Regel versucht, einen möglichst hohen Anteil der erzeugten Energie in dem Energiesystem 1 selbst zu nutzen, anstatt die erzeugte Energie in das Stromversorgungsnetz einzuspeisen. Je nach Temperatur des Wärmespeichers 9 kann die Wärmepumpensteuerung 8 entscheiden, ob und in welchem Ausmaß die mitgeteilte Überschussleistung verwendet wird.

Bei dem zweiten Steuerungstyp II durch Temperaturvorgabe wird in Korrelation zu der momentanen Überschussleistung eine gewünschte Solltemperatur in ein Solltemperatur-Register der Wärmepumpensteuerung 8 eingeschrieben. Diese Solltemperatur betrifft beispielsweise einen Warmwasser- oder Heizwasserspeicher 9. Im Beispiel in Fig. 4B entspricht dies dem Register "SetTempWS". Da im Beispiel die Wärmepumpe 7 gemäß Fig. 4A den Steuerungstyp II nicht unterstützt, ist das Register nicht verfügbar ("n.a.") und folglich auch keine Registeradresse eingetragen.

Bei dem dritten Steuerungstyp III erfolgt die Wärmepumpensteuerung 8 durch eine SG-Ready-Vorgabe. In Korrelation zu der aktuellen Überschussleistung wird mittels einer SG-Ready-Vorgabe in entsprechende SG-Ready-Betriebszustände geschaltet. In dem Beispiel gemäß Fig. 4B erfolgt die SG-Ready-Vorgabe über die Register "SGPin1" und "SGPin2" mit den Registeradressen 705 und 706. Die auf "SGPin1" und "SGPin2" auszugebenden logischen Werte für die jeweilige SG-Ready-Vorgabe Betriebszustand sind beispielsweise in der Wärmepumpen-Konfigurationsdatei WPK in Fig. 4A unter "SGNORMAL" und "SGFORCED" eingetragen. Bei "SGNORMAL" und "SGFORCED" kann auch ein Wert eingetragen sein, beispielsweise auch zusätzlich.

Der vierte Steuerungstyp IV kann bei Wärmepumpensteuerungen 8 angewendet werden, die gemäß dem Stand der Technik eine Überschussleistung von einem speziell mit der jeweiligen Wärmepumpensteuerung 8 abgestimmten Wärmepumpen-Smartmeter abfragen.

Bei dem vierten Steuerungstyp IV fragt die Wärmepumpensteuerung 8 die aktuelle Überschussleistung von der Systemsteuerung 10 ab. Die Systemsteuerung 10 simuliert dabei für die Wärmepumpensteuerung 8 ein Wärmepumpen-Smartmeter. In diesem Falle ist die Wärmepumpensteuerung 8 der MODBUS-Master. An die Stelle eines üblicherweise als MODBUS-Slave konfigurierten Wärmepumpen-Smartmeters tritt die als MODBUS-Slave konfigurierte Systemsteuerung 10 und ersetzt somit den Wärmepumpen-Smartmeter.

Da die Systemsteuerung 10 mit der Strommesseinheit 5 über die Datenleitung 15 verbunden ist, kann diese die Messwerte der Strommesseinheit 5 durch Simulation eines Wärmepumpen-Smartmeters an die Wärmepumpensteuerung 8 weiterleiten. In einer besonders vorteilhaften Ausführungsform entscheidet das Energiemanagementsystem, ob ein aktueller Messwert der Strommesseinheit 5, oder ein anderer vom Energiemanagementsystem ermittelter vorteilhafter Wert, von der Systemsteuerung 10 mittels Simulation eines Wärmepumpen-Smartmeters für die Wärmepumpensteuerung 8 bereitgestellt wird. In dem Beispiel gemäß Fig. 4A ist der Steuerungstyp IV "ControlReadSurplusPower" nicht verfügbar ("n.a."). Folglich ist in Fig. 4B das Register für einen Wert der Überschussleistung "EnergyMeterEl" ebenfalls nicht verfügbar.

In einer weiteren besonders vorteilhaften Ausführungsform ist die Systemsteuerung 10 in einen Wechselrichter 3 integriert bzw. die Systemsteuerung 10 wird funktional durch einen Wechselrichter 3 realisiert.

Wie in Fig. 4A dargestellt, umfasst die Wärmepumpen-Konfigurationsdatei WPK weitere Steuerungsparameter, insbesondere eine maximale Sollleistung ("SetPowerMax"), eine minimale Sollleistung ("SetPowerMin") oder eine maximale Solltemperatur des Wärmespeichers 9 ("SetTemperatureMax").. Die Steuerungsparameter können auch verschiedene SG-Ready-Vorgaben für den dritten Steuerungstyp III beinhalten, wie in Fig. 4A dargestellt.

Neben den Steuerungsparametern umfasst die Wärmepumpen-Konfigurationsdatei WPK verschiedene MODBUS-Parameter, wie in Fig. 4A gezeigt. Bei dem in Fig. 4A dargestellten Beispiel sind die Kommunikationsprotokolle MODBUS-TCP und MODBUS-RTU als verfügbar eingetragen ("Modbus-TCP available" und "Modbus-RTU available"). In Fig. 4A sind zu MODBUS-TCP und MODBUS-RTU weitere typische Parameter mit abgestimmten Werten zwischen einer Systemsteuerung 10 und der zu verbindenden Wärmepumpensteuerung 8 angegeben wie z.B. "TCPPort" oder "RTUBaudRate".

Neben den Steuerungsparametern und den MODBUS-Parametern umfasst die Wärmepumpen-Konfigurationsdatei WPK bei dem in Fig. 4B, in Fortsetzung von Fig. 4A, dargestellten Beispiel Datenpunktinformationen. Datenpunktinformationen spezifizieren Register für die Kommunikation. Diese Register können bei einem bestimmten Wärmepumpentyp entweder verfügbar sein ("available") oder nicht verfügbar sein ("n.a."). Bei manchen Registern sind den Werten Einheiten zugeordnet, beispielsweise ist der in dem Register "SetPowerReg" angegebene Wert eine Watt-Angabe (W). Die Einheiten sind dabei optional. Ist ein Register "available", sind folgende Angaben notwendig: Skalierfaktor, Registeradresse, Datentyp, Registertyp. Es wird also für jeden Wert eines Registers ein Skalierfaktor angegeben, für verschiedene Register eine Registeradresse in der Wärmepumpen-Konfigurationsdatei WPK angegeben - wie in Fig. 4A, 4B dargestellt. Ebenso wird ein Datentyp des betreffenden Registers sowie ein Registertyp angegeben. Manche Register können sowohl gelesen als auch beschrieben werden ("RW": Read/Write). Andere Register können lediglich ausgelesen werden ("R": Read).

Erfindungsgemäß lassen sich für jedes Wärmepumpenfabrikat bzw. für jeden Wärmepumpentyp Wärmepumpen-Konfigurationsdateien WPK definieren. Diese können je nach Typ und Modell der Wärmepumpe 7 inhaltlich unterschiedlich zueinander sein. Die Struktur der Wärmepumpen-Konfigurationsdatei WPK bleibt aber gleich, sodass die Systemsteuerung 10 des Energiesystems 1 bzw. eines Energiemanagementsystems darauf zugreifen kann. Auf diese Weise kann die Programmierung des Energiemanagementsystems bzw. der Systemsteuerung 10 einheitlich und einfach ausgeführt sein, weil die erforderlichen Anpassungen an Parameter und Steuerungstypen für die Steuerung von verschiedenen Wärmepumpen 7 mittels Einbindung einer entsprechenden Wärmepumpen-Konfigurationsdatei WPK erfolgt. Das Energiemanagementsystem ermittelt z.B. den aktuell günstigsten Energieverbrauch und liefert über die Systemsteuerung 10 beispielsweise eine entsprechende Empfehlung in einer für die Wärmepumpensteuerung 8 der Wärmepumpe 7 kompatiblen Form.

Bei einer möglichen Ausführungsform bestehen die Wärmepumpen-Konfigurationsdateien WPK im Wesentlichen aus drei Teilen, nämlich Steuerungsparametern, MODBUS-Parametern sowie Datenpunktinformationen, wie beispielhaft in Fig. 4A, 4B dargestellt.

An der Nutzerschnittstelle 13 hat zudem jeder Nutzer bzw. Betreiber die Möglichkeit, die Systemsteuerung 10 bzw. das Energiemanagementsystem seines Energiesystems 1 innerhalb eines von der WPK vorgegeben Rahmens individuell zu konfigurieren. Wie Fig. 5 beispielsweise zeigt, können dabei für die Verbindung relevante Parameter eingestellt bzw. geändert werden. Diese Parameter sind im Wesentlichen aus dem Stand der Technik bekannt und umfassen insbesondere MODBUS-Type (MODBUS-TCP, MODBUS-RTU), deren MODBUS-Parameter (Port, Offset, Slave-Adressen, Endian, Baudrate, Parity, Stopbit) sowie weitere Verbindungsparameter (beispielsweise Netzwerk- bzw. IP-Adressen wie Wechselrichter-IP, Wärmepumpen-IP "HeatpumpIP", Smartmeter-ID). Darüber hinaus kann die Steuerungsstrategie konfiguriert bzw. gewählt werden (Leistungsvorgabe bzw. "ControlSetPower", Temperaturvorgabe bzw. "ControlSetTemperature", Steuerung durch SG-Ready-Vorgabe bzw. "ControlSetSGStatus" sowie Steuerung durch Wärmepumpen-Smartmeter Simulation bzw. "ControlReadSurplusPower"). Ferner können weitere Steuerungsparameter eingestellt werden, beispielsweise Schreibintervalle "WriteInterval" zur Festlegung wie oft ein Wert gesendet werden soll oder Netzbezugsgrenzen "ThresholdPurchase" zur Festlegung ab welchem Leistungsbezug aus einem Stromversorgungsnetz vom Energiemanagementsystem eine Maßnahme zur Senkung des Energieverbrauchs gesetzt werden soll. Individuelle Eingaben von Werten über die Nutzerschnittstelle 13 werden als für die Initialisierung (SO) zu verwendende Parameter bzw. Werte vorzugsweise der Wärmepumpen-Konfigurationsdatei WPK angefügt, wobei sogenannte Default-Werte von angepassten Parametern erhalten bleiben. Wird über die Nutzerschnittstelle 13 für einen Parameter keine von einem Default-Wert abweichende individuelle Eingabe eines Werts vorgenommen, wird der entsprechende Default-Wert als zu verwendender Parameter bzw. Wert der Wärmepumpen-Konfigurationsdatei WPK angefügt und für die Initialisierung (SO) verwendet. Die Wärmepumpen-Konfigurationsdatei WPK wird bei einer bevorzugten Ausführungsform als Grundlage verwendet, um einem Nutzer bzw. Betreiber in der Nutzerschnittstelle 13 die Wahl zwischen möglichen Verbindungs- und Steuerungsoptionen sowie voreingestellte sinnvolle Default-Werte als Ausgangsbasis anzubieten.

Fig. 5 zeigt ein Beispiel für mögliche Nutzereinstellungen. Bei dem in Fig. 5 dargestellten Beispiel ist als MODBUSType MODBUS-TCP eingestellt. Eine Netzwerk- bzw. IP-Adresse der Wärmepumpensteuerung 8 (Heat Pump-IP) ist eingetragen. Es kann sich hier um einen Default-Wert oder eine Nutzereingabe handeln. In diesem Sinne könnten weitere IP-Adressen, z.B. der eines Wechselrichters 3 angegeben bzw. editierbar sein. Mögliche MODBUS-Parameter umfassen eine Portnummer "TCPPort = 502", einen MODBUS-Registeradressoffsetwert "TCPOffset", eine MODBUS-Slave-Adresse "TCPSlaveAddress" und weitere MODBUS-Parameter, wie in Fig. 5 dargestellt. Die Werte können dabei aus der Wärmepumpen-Konfigurationsdatei WPK stammen. In Fig. 5 stammen die Werte für die Modbus-Parameter aus Fig. 4A. Als Steuerungsstrategie bzw. Steuerungstyp (Control Type) ist bei dem in Fig. 5 dargestellten Beispiel Leistungsvorgabe (ControlSetPower) ausgewählt. Als Wert für die Grenze für einen Leistungsbezug "ThresholdPurchase" aus einem Stromversorgungsnetz 6 wurde 500 Watt eingetragen.

Bei einer möglichen Ausführungsform wird die Wärmepumpen-Konfigurationsdatei WPK in einer Einheit des Energiesystems 1 gespeichert. Bei dem in Fig. 1 dargestellten Beispiel kann die Wärmepumpen-Konfigurationsdatei WPK beispielsweise in dem Datenspeicher 11 der Systemsteuerung 10 gespeichert werden. Weiterhin ist es möglich, dass die Wärmepumpen-Konfigurationsdatei WPK auch in einem lokalen Speicher der Wärmepumpe 7 hinterlegt ist und bei Bedarf in den Datenspeicher 11 der Systemsteuerung 10 geladen wird. Bei einer möglichen Ausführungsform kann die Wärmepumpe 7 bereits bei Auslieferung in einem zugehörigen eigenen integrierten Datenspeicher eine gespeicherte Wärmepumpen-Konfigurationsdatei WPK aufweisen, die während oder nach Installation der Wärmepumpe 7 in das Energiesystem 1 automatisch in den Datenspeicher 11 der Systemsteuerung 10 für den weiteren Betrieb geladen wird. Bei einer weiteren möglichen Ausführungsform können beispielsweise auch alle verfügbaren Wärmepumpen-Konfigurationsdateien WPK werksseitig in einem lokalen Datenspeicher des Wechselrichters 3 abgespeichert werden, um bei Bedarf in den Datenspeicher 11 der Systemsteuerung 10 geladen zu werden. Bei einer möglichen Ausführungsform kann die Systemsteuerung 10 ihrerseits durch die Systemsteuerung des Wechselrichter 3 des Energiesystems 1 gebildet sein bzw. in diesen integriert sein. Bei einer weiteren möglichen Ausführungsform können Wärmepumpen-Konfigurationsdateien WPK über eine Cloud Platform aus einer Datenbank in den Datenspeicher 11 der Systemsteuerung 10 heruntergeladen werden.

Bei dem erfindungsgemäßen Energiesystem 1 werden zur Ansteuerung der mindestens einen Wärmepumpe 7 des Energiesystems 1 abhängig vom Steuerungstyp der Wärmepumpe 7 zugehörige Wärmepumpen-Konfigurationsdateien WPK verwendet. Hierdurch kann eine Signalisierung vom Wechselrichter 3 an die Wärmepumpe 7 ermöglicht werden, um die Wärmepumpe 7 zu veranlassen, kostengünstige Energie effizient zu nutzen. Hierbei kann berücksichtigt werden, dass verschiedene Wärmepumpenhersteller, Wärmepumpentypen und Wärmepumpenmodelle unterschiedliche Möglichkeiten bieten, diese momentan günstig zur Verfügung stehende Energie aus z.B. Überschussleistung von dem Wechselrichter 3 oder einem variablen Stromtarif zu empfangen bzw. zu übernehmen.

Bei einer möglichen Ausführungsform kann das erfindungsgemäße Energiesystem 1 Wärmepumpen 7 unterschiedlichen Steuerungstyps einbinden.

Eine herkömmliche Wärmepumpe des Steuerungstyps IV ermöglicht es, eine Photovoltaiküberschussleistung, unabhängig von einem Wechselrichter 3, zu verwerten. Dafür wird jedoch ein eigener für die Wärmepumpe 7 vorgesehener Wärmepumpen-Stromzähler bzw. Wärmepumpen-Smartmeter an dem Einspeisepunkt benötigt, um die Kompatibilität zwischen einer Wärmepumpensteuerung 8 der Wärmepumpe 7 und einem Stromzähler sicherzustellen. Das erfindungsgemäße Energiesystem 1 ermöglicht die Eingliederung einer Wärmepumpe 7 des vierten Steuerungstyps IV, ohne dafür einen zusätzlichen Wärmepumpen-Stromzähler, beispielsweise einen Wärmepumpen-Smartmeter, im Energiesystem 1 installieren zu müssen. Bei dem erfindungsgemäßen Energiesystem 1 wird für den vierten Steuerungstyps IV solch ein Wärmepumpen-Stromzähler bzw. Wärmepumpen-Smartmeter für die Wärmepumpensteuerung 8 durch die Systemsteuerung 10 eines Wechselrichters 3 über eine Steuerungsschnittstelle 12 simuliert bzw. emuliert, sodass die Installation und Konfiguration eines zusätzlichen Wärmepumpen-Stromzählers entfallen kann.

Bei einer möglichen Ausführungsform weist der Wechselrichter 3 bzw. die Systemsteuerung 10 sowie die Wärmepumpe 7 bzw. die Wärmepumpensteuerung 8 des Energiesystems 1 als Schnittstelle bzw. Steuerungsschnittstelle 12 eine MODBUS- Schnittstelle auf. Bei dieser Ausführungsform ermittelt das Energiemanagementsystem des Wechselrichters 3 einen aktuellen Leistungsüberschusswert an dem Einspeisepunkt und übermittelt den aktuellen oder einen modifizierten Leistungsüberschusswert an die Wärmepumpe 7 des Energiesystems 1 über die Steuerungsschnittstelle 12. Diese Variante bietet neben der Einsparung eines Wärmepumpen-Stromzählers den Vorteil, dass abweichend vom aktuellen Leistungsüberschusswert ein beliebiger Leistungsüberschusswert an die Wärmepumpe 7 übermittelt werden kann. So ist es z.B. möglich, bei aktuell nicht vorhandenem Leistungsüberschuss eines Energiesystems 1, dennoch der Wärmepumpe 7 einen Leistungsüberschusswert zu vermitteln. Auf diese Weise kann die Systemsteuerung 10 des Wechselrichter 3 die Wärmepumpe 7 dazu veranlassen, Energie aus dem Versorgungsnetz zu beziehen, insbesondere, wenn preislich vorteilhafte Energietarife verfügbar sind.

Bei einer möglichen Ausführungsform des erfindungsgemäßen Energiesystems 1 umfasst der Steuerungstyp der Wärmepumpe 7 einen Typ aus einer vorgegebenen Gruppe von Steuerungstypen. Bei einer möglichen Ausführungsform ist der erste Steuerungstyp I ein Steuerungstyp, bei dem die Wärmepumpe 7 durch eine Leistungsvorgabe gesteuert wird. Bei einem weiteren zweiten Steuerungstyp II wird die Wärmepumpe 7 durch eine Temperaturvorgabe gesteuert. Bei einer weiteren möglichen Ausführungsform ist die Wärmepumpe 7 entsprechend einem dritten Steuerungstyp III durch eine SG-Ready-Vorgabe steuerbar. Weiterhin kann die Wärmepumpe 7 bei einer möglichen Ausführungsform entsprechend einem vierten Steuerungstyp IV durch Simulation eines Wärmepumpen-Stromzählers gesteuert werden. Andere Steuerungstypen sind möglich.

Bei einer möglichen Ausführungsform verwendet das erfindungsgemäße Energiesystem 1 ein MODBUS-Kommunikationsprotokoll. Das MODBUS-Kommunikationsprotokoll basiert auf einer Master/Slave- Architektur. Hierbei besitzt jeder Busteilnehmer eine eindeutige Adresse. Jeder Teilnehmer darf Nachrichten über den gemeinsamen Kommunikationsbus bzw. die Schnittstelle senden. Die Kommunikation wird in der Regel durch den Master initiiert und durch einen adressierten Slave beantwortet. Mögliche Schnittstellen umfassen beispielsweise RS485, RS232, WiFi oder Ethernet. Zum Schreiben und Lesen von Datenwerten werden Register verwendet. Bei den über Steuerungstypen I, II, III steuerbaren Wärmepumpen 7 sind die verfügbaren Register der jeweiligen Wärmepumpensteuerung 8 von Bedeutung. Zumindest die für die Steuerung einer Wärmepumpe 7 benötigten Register der Wärmepumpensteuerung 8 sind mit ihren Registeradressen in der WPK hinterlegt.

Bei Steuerungstyp IV werden die Register des eingesparten Smartmeters durch die Systemsteuerung 10 bzw. den Wechselrichter 3 für die Wärmepumpensteuerung 8 simuliert.

Bei der Wärmepumpe 7 kann es sich um eine Smart-Grid-Ready-fähige Wärmepumpe handeln. Die Systemsteuerung 10 kann der Smart-Grid-Ready-fähigen Wärmepumpe 7 eine leistungs- bzw. einspeiseleistungsbezogene Einschaltempfehlung geben. Hierdurch wird der Wärmepumpensteuerung 8 der Wärmepumpe 7 mitgeteilt, zu welchen Zeiten die Wärmepumpe 7 den thermischen Speicher 9 beladen soll, sodass beispielweise möglichst viel des von der Photovoltaikanlage 2 erzeugter Photovoltaikstroms durch das Energiesystem 1 verbraucht wird, womit eine sogenannte Eigenverbrauchsoptimierung realisiert wird. Hierbei kann die Wärmepumpe 7 durch eine Anhebung einer Solltemperatur der Wärmepumpe 7 in einen Betrieb mit erhöhter Leistung geschaltet werden, was eine Anhebung des Energieverbrauchs und einer Ist-Temperatur der Wärmepumpe 7 zur Folge hat. Die Voraussetzung für die Smart-Grid-Ready-Ansteuerung ist, dass die Wärmepumpe 7 am selben Einspeise- bzw. Zählpunkt wie der Wechselrichter 3 angeschlossen ist. Dies gilt auch für die übrigen genannten Steuerungstypen von Wärmepumpen.

Eine Smart-Grid-Ready-fähige Wärmepumpe 7 verfügt üblicherweise über vier ansteuerbare SG Ready Betriebszustände. Diese werden gemäß dem Stand der Technik über eine SG Ready Schnittstelle gesteuert. Die SG Ready Schnittstelle der Wärmepumpensteuerung 8 besteht zumindest aus zwei logischen Eingängen (SGPin1, SGPin2), über die einer der vier Betriebszustände durch eine Systemsteuerung 10 eines Energiemanagementsystems vorgegeben werden kann. Gängige "SG Ready"-Spezifikationen beschreiben üblicherweise die folgenden vier SG Ready Betriebszustände für Wärmepumpen 7:
In einem ersten SG Ready Betriebszustand SGMIN wird die Wärmepumpe 7 am Betrieb gehindert, d.h. die Wärmepumpe 7 befindet sich in einem Sperrbetriebszustand.

In einem zweiten SG Ready Betriebszustand SGNORMAL wird die Wärmepumpe 7 normal betrieben. In diesem Betriebszustand läuft die Wärmepumpe 7 in einem energieeffizienten Normalbetrieb mit anteiliger Wärmespeicherfüllung.

In einem dritten SG Ready Betriebszustand SGFORCED arbeitet die Wärmepumpe 7 in einem verstärkten Betrieb für Warmwasseraufbereitung und/oder Raumheizung. Hierbei handelt es sich nicht um einen direkten Anlaufbefehl, sondern um eine Einschaltempfehlung.

In einem vierten SG Ready Betriebszustand SGMAX erhält die Wärmepumpensteuerung 8 einen definitiven Anlaufbefehl.

Eine Wärmepumpensteuerung 8 kann von der Systemsteuerung 10 bzw. dem Energiemanagementsystem zur Eigenverbrauchsoptimierung mit einer vorgegebenen elektrischen Leistungsaufnahme angesteuert werden.

Gemäß einer erfindungsgemäßen Ausführungsform wird eine Smart-Grid-Ready-fähige Wärmepumpe 7, anstatt über die SG Ready Schnittstelle, über eine Steuerungsschnittstelle 12, vorzugsweise eine Modbus-Schnittstelle von einem Wechselrichter 3, angesteuert. Dabei wird beispielsweise einer von vier SG Ready Betriebszuständen der Wärmepumpe 7 über die Modbus-Schnittstelle bzw. Steuerungsschnittstelle 12 vorgegeben.

Das in Fig. 1 dargestellte erfindungsgemäße Energiesystem 1 beinhaltet eine Systemsteuerung 10 mit Kommunikationsschnittstelle (z.B. Modbus-Schnittstelle) zum Betrieb eines Energiemanagementsystems, welche über Wärmepumpen-Konfigurationsdateien WPK als universelle Steuerungsschnittstelle 12 für eine oder mehrere Wärmepumpen 7 bzw. Wärmepumpensteuerungen 8 konfigurierbar ist. Dies bietet den Vorteil, dass die Energiemanagementsoftware für die Systemsteuerung 10 nur einmal entwickelt werden muss, und zwar in einer erfindungsgemäß universellen Ausführung. Die Anpassung, d.h. die Registerbeschreibung und/oder Regelungsstrategie, für die jeweilige Wärmepumpe 7 kann mithilfe der Wärmepumpen-Konfigurationsdatei WPK erfolgen. Bei einer möglichen Ausführungsform können Wärmepumpen-Konfigurationsdateien WPK nachträglich dem Energiemanagementsystem zur Verfügung gestellt werden (z.B. aus einer Datenbank heruntergeladen werden).

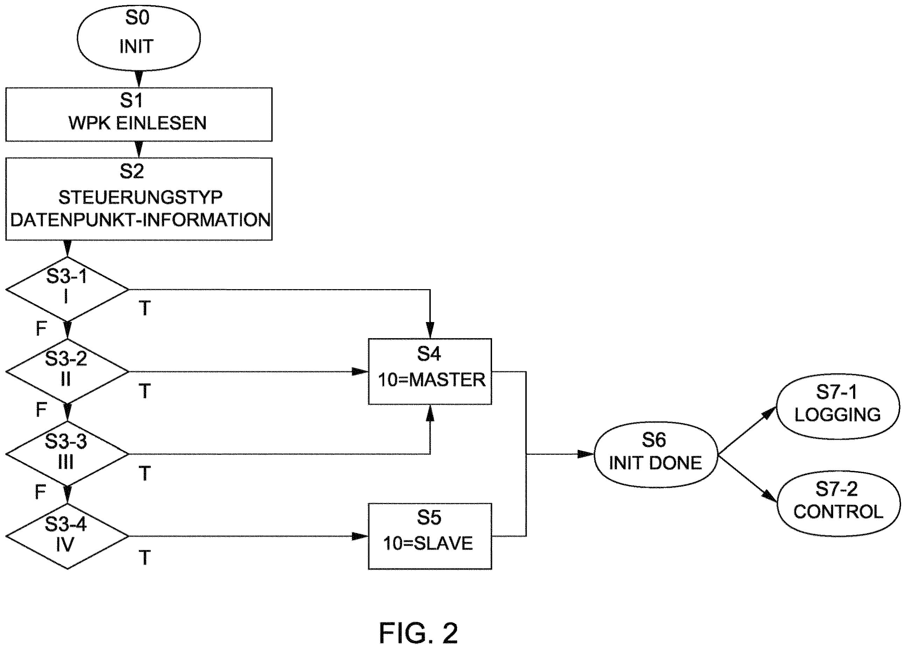

Fig. 2 zeigt ein Ablaufdiagramm zur Darstellung eines Beispiels eines Initialisierungsvorganges einer Systemsteuerung 10 bzw. Wärmepumpe 7 eines erfindungsgemäßen Energiesystems 1. Der Initialisierungsvorgang (Schritt S0 "INIT") wird gestartet, wenn ein Nutzer die eingetragenen Parameter und Werte an der Nutzerschnittstelle 13 bestätigt. Im Schritt S1 "WPK EINLESEN" wird die Wärmepumpen-Konfigurationsdatei WPK durch die Systemsteuerung 10 aus dem Datenspeicher 11 ausgelesen. Die Wärmepumpen-Konfigurationsdatei WPK kann dabei vor dem Initialisierungsvorgang beispielsweise von einem Webserver einer Cloud Plattform in den lokalen Datenspeicher 11 heruntergeladen, oder durch eine Leseeinheit der Systemsteuerung 10 aus einem Datenträger in den lokalen Datenspeicher 11 geladen worden sein. Die Wärmepumpen-Konfigurationsdatei WPK gibt in Schritt S2 in Abhängigkeit von einem gewählten Steuerungstyp für die betreffende Wärmepumpensteuerung 8 Datenpunkt-Informationen, wie z.B. in Fig. 4B dargestellt, an. Danach folgt die Systemsteuerung entsprechend dem gewählten Steuerungstyp (I, II, III, IV) einem der Schritte S3-1, S3-2, S3-3, S3-4. Weist die Wärmepumpe 7 einen der ersten drei Steuerungstypen (I, II, III) auf, wird im Schritt S6 die Systemsteuerung 10 des Energiesystems 1 automatisch als MODBUS-Master konfiguriert. Falls die Wärmepumpe 7 durch Simulation bzw. Emulation eines Wärmepumpen-Stromzählers steuerbar ist (Steuerungstyp IV), wird im Schritt S5 die Systemsteuerung 10 als MODBUS-Slave konfiguriert, sodass diese von einer Wärmepumpensteuerung 8 als Wärmepumpen-Stromzähler erkannt wird. Mit der Übernahme aller anzuwendender Parameter bzw. Werte aus der Wärmepumpen-Konfigurationsdatei WPK wird der Initialisierungsvorgang im Schritt S6 "INIT DONE" abgeschlossen. Daran anschließend können mit den Schritten S7-1 und S7-4 zwei weitere Abläufe parallel eingeleitet werden.

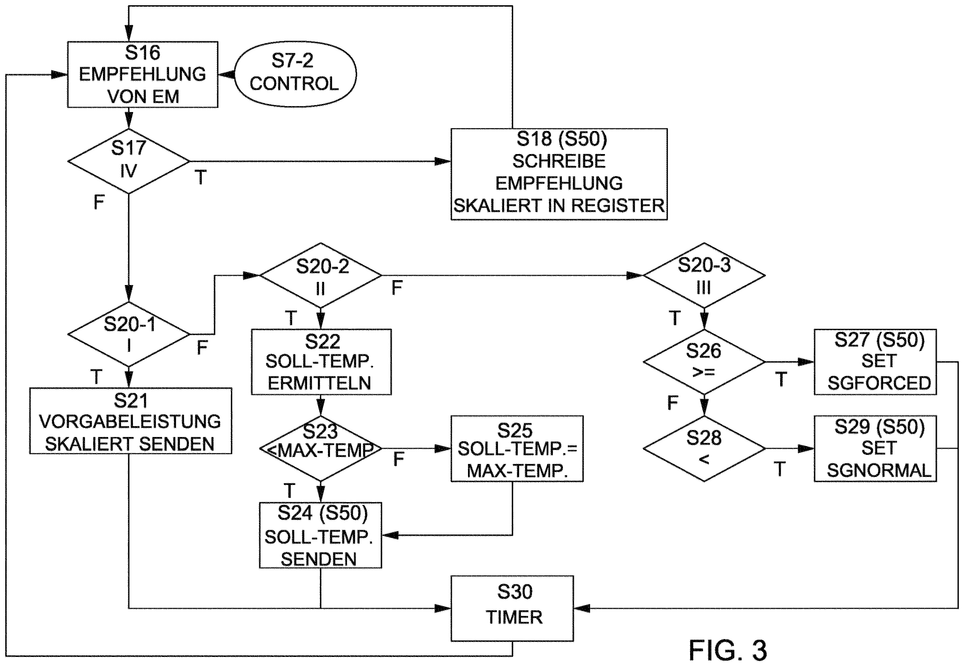

Fig. 3 zeigt ein Ablaufdiagramm einer Ausführungsform eines möglichen Hauptprogramms zur Steuerung einer Wärmepumpe 7 (S7-2 "CONTROL") nach Abschluss des in Fig. 2 dargestellten Initialisierungsvorganges.

In einem Schritt S16 "EMPFEHLUNG VON EM" wird eine Empfehlung von dem Energiemanagementsystem EM bereitgestellt. Im nächsten Schritt S17 wird geprüft, ob der IV. Steuerungstyp vorliegt und somit eine Steuerung durch Simulation eines Wärmepumpen-Stromzählers erfolgt. Falls dies der Fall ist ("T" TRUE), wird im Schritt S18 von der Systemsteuerung 10 die Empfehlung aus Schritt S16 entsprechend der Wärmepumpen-Konfigurationsdatei WPK skaliert und über das Register "EnergyMeterEl" der Systemsteuerung 10 für die Wärmepumpensteuerung 8 bereitgestellt. Die Registeradresse vom Register EnergyMeterEl entspricht dabei der Registeradresse, auf der die Wärmepumpensteuerung 8 als MODBUS-Master einen Wert eines Wärmepumpenstromzählers abfragt. In Fig. 4B ist das Register "EnergyMeterEl" nicht verfügbar. Im Falle eines verfügbaren Steuerungstyps IV wäre es jedoch verfügbar und definiert. Falls nicht der IV. Steuerungstyp vorliegt ("F" FALSE), wird im Schritt S20-1 geprüft, ob für die Wärmepumpe 7 der Steuerungstyp I vorgegeben ist. Falls Steuerungstyp I vorgegeben ist ("T" TRUE) wird die Wärmepumpe 7 durch Leistungsvorgabe gesteuert - beispielsweise durch eine maximale Leistung einer Photovoltaikanlage - und im Schritt S21 von der Systemsteuerung 10 über die Steuerungsschnittstelle 12 die Empfehlung aus Schritt S16 entsprechend der Wärmepumpen-Konfigurationsdatei WPK skaliert an die Wärmepumpensteuerung 8 der Wärmepumpe 7 gesendet bzw. übertragen. Dabei wird der Wert der Empfehlung vom Energiemanagementsystem 10 aus Schritt S16 mit dem entsprechenden Skalierungsfaktor multipliziert, um als eine Vorgabeleistung Psoll im Beispiel von Fig. 4B in das Register "SetPowerReg" mit der Registeradresse "1000" geschrieben zu werden. Mit Schritt S30 "TIMER" folgt eine Wartezeit, in der das Energiemanagementsystem den Energiefluss des Energiesystems 1 beobachtet, um nach Ablauf der Wartezeit eine neu ermittelte Empfehlung im Schritt S16 abzugeben.

Liefert Schritt S20-1 das Ergebnis "F" (FALSE), weil der Steuerungstyp I nicht vorgegeben ist, wird im Schritt S20-2 geprüft, ob die Wärmepumpe 7 entsprechend dem Steuerungstyp II gesteuert wird. Falls Steuerungstyp II vorgegeben ist ("T" TRUE) wird die Wärmepumpe 7 durch Temperaturvorgabe gesteuert und im Schritt S22 von der Systemsteuerung 10 eine Solltemperatur für die Wärmepumpe 7 ermittelt. Die Solltemperatur wird dahingehend ermittelt, dass sie einer gewünschten Leistungsaufnahme der Wärmepumpe 7 entspricht. Zum Beispiel kann die gewünschte Erhöhung einer Ist-Temperatur des Wärmespeichers 9 durch Division der Vorgabeleistung Psoll durch einen Leistungssprung pro Kelvin einer Wärmepumpe 7 berechnet werden. Die Summe aus Ist-Temperatur und gewünschter Erhöhung entspricht dann bevorzugt der ermittelten Solltemperatur des Wärmespeichers 9. Diese darf eine maximale Temperatur des Wärmespeichers nicht überschreiten, weshalb im Schritt S23 eine entsprechende Abfrage erfolgt. Falls die ermittelte Solltemperatur unter der maximalen Temperatur liegt "T" (TRUE), wird der Wert der Solltemperatur nicht weiter verändert. Falls die ermittelte Solltemperatur über der maximalen Temperatur liegt "F" (FALSE), wird der Wert der Solltemperatur im Schritt S25 mit dem Wert der maximalen Temperatur gleichgesetzt. Im Schritt S24 wird die Solltemperatur über die Steuerungsschnittstelle 12 entsprechend der Wärmepumpen-Konfigurationsdatei WPK skaliert an die Wärmepumpensteuerung 8 der Wärmepumpe 7 gesendet bzw. übertragen. Die Solltemperatur würde gemäß dem Beispiel in Fig. 4B als Temperaturvorgabe in das Register "SetTempWS" mit der entsprechenden Registeradresse geschrieben. Im Beispiel Fig. 4B ist das Register "SetTempWS" nicht verfügbar "n.a.". Im Falle eines verfügbaren Steuerungstyps II wäre es jedoch verfügbar und definiert. Mit Schritt S30 "TIMER" folgt eine Wartezeit, in der das Energiemanagementsystem den Energiefluss des Energiesystems 1 beobachtet, um nach Ablauf der Wartezeit eine neu ermittelte Empfehlung für die Vorgabeleistung Psoll im Schritt S16 abzugeben.

Liefert Schritt S20-2 das Ergebnis "F" (FALSE), weil der Steuerungstyp II nicht vorgegeben ist, wird im Schritt S20-3 geprüft, ob die Wärmepumpe 7 entsprechend dem Steuerungstyp III gesteuert wird. Falls Steuerungstyp III vorgegeben ist ("T" TRUE), wird die Wärmepumpe 7 durch SG-Ready-Vorgabe gesteuert und von der Systemsteuerung 10 kann im Schritt S26 geprüft werden, ob die Vorgabeleistung größer oder gleich einer vorgegebenen Einschaltschwelle ist. (Eine entsprechende Einschaltschwelle ist in Fig. 5 als *"SGThresholdForced"* mit dem Wert 1000 Watt angedeutet. Für das konkrete Beispiel in Fig. 5 ist dieser Parameter jedoch nicht relevant. Um dies anzudeuten, ist *"SGThresholdForced"* in kursiver Schrift angeführt.). Falls dies der Fall ist, wird im Schritt S27 die Wärmepumpensteuerung 8 der Wärmepumpe 7 über die Steuerungsschnittstelle 12 von der Systemsteuerung 10 auf den dritten SG Ready Betriebszustand "SGFORCED" gesetzt, um einen erhöhten Betrieb im Sinne des dritten SG Ready Betriebszustandes zu aktivieren. Ist umgekehrt die Vorgabeleistung Psoll niedriger als die Einschaltschwelle, wird dies im Schritt S28 festgestellt und im Schritt S29 die Wärmepumpensteuerung 8 der Wärmepumpe 7 über die Steuerungsschnittstelle 12 von der Systemsteuerung 10 auf den zweiten SG Ready Betriebszustand SGNORMAL gesetzt, um einen Normalbetrieb im Sinne des zweiten SG Ready Betriebszustandes zu aktivieren.

Für das Setzen eines SG Ready Betriebszustandes verwendet die Systemsteuerung 10 das in der Wärmepumpen-Konfigurationsdatei WPK für einen SG Ready Betriebszustand vorgegebene Muster, beispielsweise ein Muster aus SGPin1 und SGPin2 wie in Fig. 4A dargestellt. Die Muster für die verschiedenen SG Ready Betriebszustände sind in der Regel für Wärmepumpen verschiedener Hersteller nicht einheitlich.

Nach Schritt S27 und S29 folgt der bereits zuvor beschriebene Warte-Schritt S30.

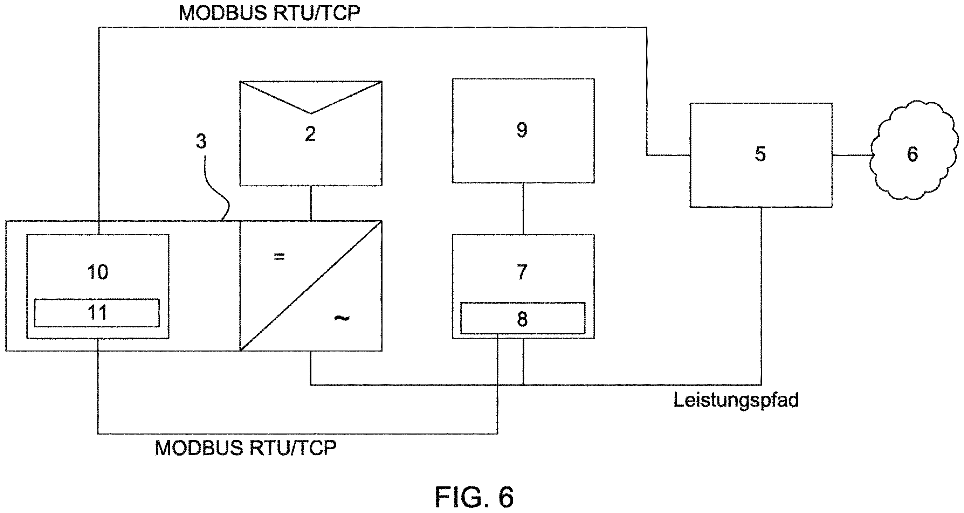

Fig. 6 zeigt eine Systemsteuerung 10, welche in einem Wechselrichter 3 integriert ist bzw. bei der es sich um die Systemsteuerung 10 eines Wechselrichters 3 handeln kann. Selbiges gilt für den Datenspeicher 11.

Die übrigen Einheiten 2, 5, 6, 7, 8, 9 in Fig. 6 entsprechen der in Fig. 1 dargestellten Anordnung.

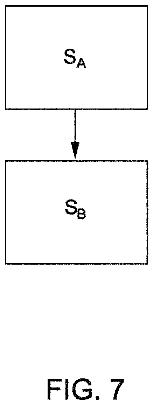

Fig. 7 zeigt ein Ablaufdiagramm zur Darstellung eines Ausführungsbeispiels eines erfindungsgemäßen Verfahrens zur Steuerung einer Wärmepumpe 7. Das Verfahren zum Steuern der Wärmepumpe 7 weist bei dem dargestellten Ausführungsbeispiel im Wesentlichen zwei Hauptschritte auf.

In einem ersten Schritt S_{A} wird eine Wärmepumpen-Konfigurationsdatei WPK in einem Datenspeicher 11 einer Systemsteuerung 10 eines Energiemanagementsystems 1 geladen. Anschließend erfolgt im Schritt S_{B} eine Kommunikation der Systemsteuerung 10 des Energiesystems 1 mit einer für die Wärmepumpe 7 vorgesehenen Wärmepumpensteuerung 8 entsprechend einem in der Wärmepumpen-Konfigurationsdatei WPK angegebenen Steuerungstyp. Hierdurch wird die Wärmepumpe 7 in ein Energiemanagementsystem des Energiesystems 1 eingebunden. Die Kommunikation S_{B} zwischen der Wärmepumpensteuerung 8 und der Systemsteuerung 10 erfolgt vorzugsweise bidirektional. Die Kommunikation erfolgt dabei über die Steuerungsschnittstelle 12, wie in Fig. 1 dargestellt. Die Wärmepumpensteuerung 8 kann in der Wärmepumpe 7 integriert sein oder über eine Schnittstelle mit der Wärmepumpe 7 lokal verbunden sein. Die Wärmepumpensteuerung 8 steuert lokal die Wärmepumpe 7 und kommuniziert dabei vorzugsweise im Hintergrund mit der Systemsteuerung 10 über die Steuerungsschnittstelle 12. Die geladene Wärmepumpen-Konfigurationsdatei WPK gibt vorzugsweise zumindest ein Kommunikationsprotokoll zur Kommunikation der Systemsteuerung 10 mit der Wärmepumpensteuerung 8 an. Demzufolge erfolgt die bidirektionale Kommunikation zwischen der Systemsteuerung 10 und der Wärmepumpensteuerung 8 der Wärmepumpe 7 über die Steuerungsschnittstelle 12 entsprechend dem Kommunikationsprotokoll, das von der zugehörigen Wärmepumpen-Konfigurationsdatei WPK, die für die Wärmepumpe 7 erstellt, und die in dem Datenspeicher 11 der Systemsteuerung 10 geladen worden ist. Bei einer möglichen Ausführungsform weist das angegebene Kommunikationsprotokoll ein MODBUS-Kommunikationsprotokoll, insbesondere ein MODBUS-TCP-Kommunikationsprotokoll oder ein MODBUS-RTU-Kommunikationsprotokoll auf. Die während der Kommunikation im Schritt S_{B} erfolgte Steuerung der zugehörigen Wärmepumpe 7 durch die Wärmepumpensteuerung 8 kann bei einer möglichen Ausführungsform derart erfolgen, dass ein Eigenverbrauch optimiert wird oder eine Effizienz hinsichtlich des Eigenverbrauchs bzw. Energieverbrauchs erhöht wird. Bei einer möglichen Ausführungsform kann eine individuelle Konfiguration über eine Nutzerschnittstelle innerhalb eines von der Wärmepumpen-Konfigurationsdatei WPK vorgegebenen Rahmens oder Formats durchgeführt werden. Beispielsweise können Werte editiert und parametrisiert werden.

Mit dem erfindungsgemäßen Energiemanagementsystem bzw. Systemsteuerung 10 eines Energiesystems 1 kann die Steuerung bzw. Regelung der Wärmepumpe 7 für unterschiedliche Wärmepumpentypen, welche unterschiedlich angesteuert werden, erfolgen. Wärmepumpen 7 unterschiedlichen Typs können somit in einfacher Weise in das erfindungsgemäße Energiesystem 1 eingebunden werden. Ferner ist ein einfacher Austausch einer bestehenden Wärmepumpe 7 durch eine andere Wärmepumpe eines anderen Steuerungstyps möglich.

## Patentansprüche

1. Energiesystem (1) mit
mindestens einer elektrischen Verbrauchseinheit (4) und mindestens einer Wärmepumpe (7), welche eine Wärmepumpensteuerung (8) aufweist, wobei die Wärmepumpe (7) einen oder mehrere Steuerungstypen aus einer vorgegebenen Gruppe von Steuerungstypen unterstützt, wobei die Gruppe der Steuerungstypen folgende Steuerungstypen umfasst:
einen ersten Steuerungstyp (I) bei dem die Wärmepumpe (7) durch Leistungsvorgabe steuerbar ist,
einen zweiten Steuerungstyp (II) bei dem die Wärmepumpe (7) durch Temperaturvorgabe steuerbar ist,
einen dritten Steuerungstyp (III) bei dem die Wärmepumpe (7) durch eine SG-Ready-Vorgabe steuerbar ist, und
einen vierten Steuerungstyp (IV) bei dem die Wärmepumpe (7) durch Simulation eines Wärmepumpen-Stromzählers steuerbar ist;
einem Wechselrichter (3) zur Umwandlung einer elektrischen Gleichspannung in eine Wechselspannung, die zur Versorgung der zumindest einen elektrischen Verbrauchseinheit (4) nutzbar und durch die mindestens eine Wärmepumpe (7) in Wärme umwandelbar ist,
eine Systemsteuerung (10) mit einem Datenspeicher (11), in welchen eine für verschiedene Typen von Wärmepumpen (7) konfigurierbare Wärmepumpen-Konfigurationsdatei (WPK) geladen wird, wobei die Wärmepumpen-Konfigurationsdatei (WPK) zumindest einen von der Wärmepumpe (7) unterstützten Steuerungstyp angibt und konfigurierbare Betriebsparameter zur Parametrisierung des Steuerungstyps und/oder der mindestens einen Wärmepumpe (7) beinhaltet;
wobei die mindestens eine Wärmepumpe (7) durch die Systemsteuerung (10) über eine Steuerungsschnittstelle (12) entsprechend der Wärmepumpen-Konfigurationsdatei (WPK) steuerbar ist, und
wobei eine Kommunikation der Systemsteuerung (10) mit der Wärmepumpensteuerung (8) entsprechend dem zumindest einem in der Wärmepumpen-Konfigurationsdatei (WPK) angegebenen Steuerungstyp der Wärmepumpe (7) erfolgt.

2. Energiesystem nach Anspruch 1,
wobei in der Wärmepumpen-Konfigurationsdatei (WPK) zumindest ein Kommunikationsprotokoll zur Kommunikation der Systemsteuerung (10) mit der Wärmepumpensteuerung (8) angegeben ist,
wobei das in der Wärmepumpen-Konfigurationsdatei (WPK) angegebene Kommunikationsprotokoll ein MODBUS-Kommunikationsprotokoll, insbesondere ein MODBUS-TCP-Kommunikationsprotokoll oder ein MODBUS-RTU-Kommunikationsprotokoll, aufweist.

3. Energiesystem nach Anspruch 2,
wobei die Systemsteuerung (10) mit der Wärmepumpensteuerung (8) über die Steuerungsschnittstelle (12) oder einen Bus des Energiesystems (1) entsprechend einem in der Wärmepumpen-Konfigurationsdatei (WPK) angegebenen Kommunikationsprotokoll bidirektional kommuniziert.

4. Energiesystem nach Anspruch 2 oder 3,
wobei die Systemsteuerung (10) in Abhängigkeit von dem in der Wärmepumpen-Konfigurationsdatei (WPK) angegebenen Steuerungstyp automatisch als Mastergerät oder als Slavegerät konfiguriert wird.

5. Energiesystem nach Anspruch 3 oder4
wobei die Wärmepumpen-Konfigurationsdatei (WPK) eine Netzwerk- bzw. IP-Adresse der Wärmepumpensteuerung (8) zur Kommunikation mit der Systemsteuerung (10) des Energiesystems (1) entsprechend dem in der Wärmepumpen-Konfigurationsdatei (WPK) der Wärmepumpe (7) angegebenen Datenpunkt-Informationen beinhaltet,
wobei die Wärmepumpen-Konfigurationsdatei (WPK) der Wärmepumpe (7) eine JSON-, XML-, CSV- oder TXT-Datei aufweist.

6. Energiesystem nach einem der vorangehenden Ansprüche,
wobei die Systemsteuerung (10) in dem Wechselrichter (3) des Energiesystems (1) integriert ist, oder wobei die Systemsteuerung (10) durch eine Steuerung des Wechselrichters (3) zur Bildung eines Energiemanagementsystems ausgebildet ist.

7. Energiesystem nach Anspruch 6,
wobei die Steuerungsschnittstelle (12) durch eine MODBUS-Schnittstelle des Wechselrichters (3) und der Wärmepumpe (7) gebildet ist,

8. Energiesystem nach einem der vorangehenden Ansprüche ,
wobei das Energiesystem (1) an ein Stromversorgungsnetz (6) über eine Strommesseinheit (5) angeschlossen ist, die Messdaten an die Systemsteuerung (10) oder ein Energiemanagementsystem des Energiesystems (1) liefert.

9. Energiesystem nach einem der vorangehenden Ansprüche,
wobei die Wärmepumpen-Konfigurationsdatei (WPK) über eine Nutzerschnittstelle (13) der Systemsteuerung (10) oder eines Energiemanagementsystems des Energiesystems (1) auswählbar und erweiterbar ist.

10. Energiesystem nach einem der vorangehenden Ansprüche,
wobei die Wärmepumpen-Konfigurationsdatei (WPK) von einem Webserver einer Cloud-Plattform über ein Datennetzwerk in den lokalen Datenspeicher (11) der Systemsteuerung (10) des Energiesystems (1) geladen wird, oder wobei die Wärmepumpen-Konfigurationsdatei (WPK) durch eine Leseeinheit der Systemsteuerung (10) aus einem Datenträger in den lokalen Datenspeicher (11) der Systemsteuerung (10) des Energiesystems (1) geladen wird.

11. Verfahren zum Steuern einer Wärmepumpe (7) mit den Schritten:
- Laden (S_{A}) einer für verschiedene Typen von Wärmepumpen (7) Wärmepumpen-Konfigurationsdatei (WPK) in einen Datenspeicher (11) einer Systemsteuerung (10) eines Energiesystems (1), wobei die Wärmepumpen-Konfigurationsdatei (WPK) zumindest einen von der Wärmepumpe (7) unterstützten Steuerungstyp angibt und konfigurierbare Betriebsparameter zur Parametrisierung des Steuerungstyps und/oder der Wärmepumpe (7) beinhaltet; und
- Kommunizieren (S_{B}) der Systemsteuerung (10) des Energiesystems (1) mit einer für die Wärmepumpe (7) vorgesehenen Wärmepumpensteuerung (8) entsprechend dem in der Wärmepumpen-Konfigurationsdatei (WPK) angegebenen Steuerungstyp, wodurch die Wärmepumpe (7) in ein Energiemanagementsystem des Energiesystems (1) eingebunden wird, wobei die Wärmepumpe (7) einen oder mehrere Steuerungstypen aus einer vorgegebenen Gruppe von Steuerungstypen unterstützt, und wobei die Steuerungstypen umfassen:
einen ersten Steuerungstyp (I) bei dem die Wärmepumpe (7) durch Leistungsvorgabe gesteuert wird,
einen zweiten Steuerungstyp (II) bei dem die Wärmepumpe (7) durch Temperaturvorgabe gesteuert wird,
einen dritten Steuerungstyp (III) bei dem die Wärmepumpe (7)durch eine SG-Ready-Vorgabe gesteuert wird, und einen vierten Steuerungstyp (IV) bei dem die Wärmepumpe (7) durch Simulation oder Emulation eines Wärmepumpen-Stromzählers gesteuert wird.

12. Verfahren nach Anspruch 11,
wobei in der geladenen Wärmepumpen-Konfigurationsdatei (WPK) ferner zumindest ein Kommunikationsprotokoll zur Kommunikation der Systemsteuerung (10) mit der Wärmepumpensteuerung (8) angegeben ist, und die Kommunikation zwischen der Systemsteuerung (10) und der Wärmepumpensteuerung (8) entsprechend dem angegebenen Kommunikationsprotokoll erfolgt,
wobei das Kommunikationsprotokoll ein MODBUS-Kommunikationsprotokoll, insbesondere ein MODBUS-TCP-Kommunikationsprotokoll oder ein MODBUS-RTU-Kommunikationsprotokoll, aufweist.

13. Systemsteuerung (10) für ein Energiesystem (1) mit mindestens einer Wärmepumpe (7), wobei die Wärmepumpe (7) einen oder mehrere Steuerungstypen aus einer vorgegebenen Gruppe von Steuerungstypen unterstützt, wobei die Gruppe von Steuerungstypen die folgenden Steuerungstypen umfasst:
einen ersten Steuerungstyp (I) bei dem die Wärmepumpe (7) durch Leistungsvorgabe steuerbar ist,
einen zweiten Steuerungstyp (II) bei dem die Wärmepumpe (7) durch Temperaturvorgabe steuerbar ist,
einen dritten Steuerungstyp (III) bei dem die Wärmepumpe (7) durch eine SG-Ready-Vorgabe steuerbar ist, und einen vierten Steuerungstyp (IV) bei dem die Wärmepumpe (7) durch Simulation oder Emulation eines Wärmepumpen-Stromzählers steuerbar ist, wobei die Systemsteuerung (10) umfasst:
einem Datenspeicher (11), in welchen eine Wärmepumpen-Konfigurationsdatei (WPK) für eine Wärmepumpe (7) geladen wird, wobei die Wärmepumpen-Konfigurationsdatei (WPK) für verschiedene Typen von Wärmepumpen (7) konfigurierbar ist, zumindest einen von der Wärmepumpe (7) unterstützten Steuerungstyp angibt und konfigurierbare Betriebsparameter zur Parametrisierung des Steuerungstyps und/oder der Wärmepumpe (7) beinhaltet; und
einer Steuerungsschnittstelle (12), über welche die Systemsteuerung (10) mit einer für die Wärmepumpe (7) vorgesehenen Wärmepumpensteuerung (8) entsprechend dem in der geladenen Wärmepumpen-Konfigurationsdatei (WPK) angegebenen Steuerungstyp zur Einbindung der Wärmepumpe (7) in das Energiemanagementsystem kommuniziert.

## Claims

1. Energy system (1) comprising
at least one electrical consumer unit (4) and
at least one heat pump (7) which has a heat pump controller (8), the heat pump (7) supporting one or more control types from a predetermined group of control types, the group of control types comprising the following control types:
a first control type (I) where the heat pump (7) is controllable by performance specification,
a second control type (II) where the heat pump (7) is controllable by temperature specification,
a third control type (III) where the heat pump (7) is controllable by SG Ready specification, and
a fourth control type (IV) where the heat pump (7) is controllable by simulating a heat pump electricity meter;
an inverter (3) for converting a direct electric current into an alternating current, which can be used for powering the at least one electrical consumer unit (4) and can be converted into heat by the at least one heat pump (7),
a system controller (10) having a data store (11) to which a heat pump configuration file (WPK) configurable for different types of heat pumps (7) is loaded, the heat pump configuration file (WPK) specifying at least one control type which is supported by the heat pump (7) and containing configurable operating parameters for parameterising the control type and/or the at least one heat pump (7);
wherein the at least one heat pump (7) is controllable by the system controller (10) via a control interface (12) in accordance with the heat pump configuration file (WPK), and wherein communication of the system controller (10) with the heat pump controller (8) takes place in accordance with the at least one control type of the heat pump (7) specified in the heat pump configuration file (WPK).

2. Energy system according to claim 1,
wherein at least one communication protocol for communication of the system controller (10) with the heat pump controller (8) is specified in the heat pump configuration file (WPK),
wherein the communication protocol specified in the heat pump configuration file (WPK) includes a MODBUS communication protocol, in particular a MODBUS TCP communication protocol or a MODBUS RTU communication protocol.

3. Energy system according to claim 2,
wherein the system controller (10) communicates with the heat pump controller (8) bidirectionally via the control interface (12) or a bus of the energy system (1) in accordance with a communication protocol specified in the heat pump configuration file (WPK).

4. Energy system according to either claim 2 or claim 3,
wherein the system controller (10) is automatically configured as a master device or slave device as a function of the control type specified in the heat pump configuration file (WPK).

5. Energy system according to either claim 3 or claim 4,
wherein the heat pump configuration file (WPK) contains a network address or IP address of the heat pump controller (8) for communication with the system controller (10) of the energy system (1) in accordance with the data point information specified in the heat pump configuration file (WPK) of the heat pump (7),
wherein the heat pump configuration file (WPK) of the heat pump (7) includes a JSON, XML, CSV or TXT file.

6. Energy system according to any of the preceding claims,
wherein the system controller (10) is integrated into the inverter (3) of the energy system (1) or wherein the system controller (10) is formed by a controller of the inverter (3) to form an energy management system.

7. Energy system according to claim 6,
wherein the control interface (12) is formed by a MODBUS interface of the inverter (3) and of the heat pump (7).

8. Energy system according to any of the preceding claims,
wherein the energy system (1) is connected to a power supply network (6) via a current measurement unit (5), which supplies measurement data to the system control (10) or to an energy management system of the energy system (1).

9. Energy system according to any of the preceding claims,
wherein the heat pump configuration file (WPK) can be selected and expanded via a user interface (13) of the system controller (10) or of an energy management system of the energy system (1).

10. Energy system according to any of the preceding claims,
wherein the heat pump configuration file (WPK) is loaded from a Web server of a cloud platform to the local data store (11) of the system controller (10) of the energy system (1) via a data network, or wherein the heat pump configuration file (WPK) is loaded from a data medium to the local data store (11) of the system controller (10) of the energy system (1) by a read unit of the system controller (10).

11. Method for controlling a heat pump (7), comprising the steps of:
- loading (S_{A}) a heat pump configuration file (WPK) for different types of heat pumps (7) to a data store (11) of a system controller (10) of an energy system (1), the heat pump configuration file (WPK) specifying at least one control type supported by the heat pump (7) and containing configurable operating parameters for parameterising the control type and/or the heat pump (7); and
- communication (S_{B}) of the system controller (10) of the energy system (1) with a heat pump controller (8) provided for the heat pump (7) in accordance with the control type specified in the heat pump configuration file (WPK), causing the heat pump (7) to be linked into an energy management system of the energy system (1), the heat pump (7) supporting one or more control types from a predetermined group of control types, and the control types comprising:
a first control type (I) where the heat pump (7) is controllable by performance specification,
a second control type (II) where the heat pump (7) is controllable by temperature specification,
a third control type (III) where the heat pump (7) is controllable by SG Ready specification, and
a fourth control type (IV) where the heat pump (7) is controllable by simulating or emulating a heat pump electricity meter.

12. Method according to claim 11,
wherein at least one communication protocol for communication of the system controller (10) with the heat pump controller (8) is further specified in the loaded heat pump configuration file (WPK), and the communication between the system controller (10) and the heat pump controller (8) takes place in accordance with the specified communication protocol,
wherein the communication protocol includes a MODBUS communication protocol, in particular a MODBUS TCP communication protocol or a MODBUS RTU communication protocol.

13. System controller (10) for an energy system (1) comprising at least one heat pump (7), the heat pump (7) supporting one or more control types from a predetermined group of control types, the group of control types comprising the following control types:
a first control type (I) where the heat pump (7) is controllable by performance specification,
a second control type (II) where the heat pump (7) is controllable by temperature specification,
a third control type (III) where the heat pump (7) is controllable by SG Ready specification, and
a fourth control type (IV) where the heat pump (7) is controllable by simulating or emulating a heat pump electricity meter, wherein the system controller (10) comprises:
a data store (11) to which a heat pump configuration file (WPK) for a heat pump (7) is loaded, the heat pump configuration file (WPK) being configurable for different types of heat pumps (7), specifying at least one control type which is supported by the heat pump (7) and containing configurable operating parameters for parameterising the control type and/or the heat pump (7);
a control interface (12) via which the system controller (10) communicates with a heat pump controller (8) provided for the heat pump (7) in accordance with the control type, for linking the heat pump (7) into the energy management system, specified in the loaded heat pump configuration file (WPK).

## Revendications

1. Système énergétique (1) comportant :
au moins une unité de consommation électrique (4) et
au moins une pompe à chaleur (7) qui présente une commande de pompe à chaleur (8), la pompe à chaleur (7) supportant un ou plusieurs types de commande parmi un groupe prédéfini de types de commande, le groupe de types de commande comprenant les types de commande suivants :
un premier type de commande (I) dans lequel la pompe à chaleur (7) peut être commandée par une consigne de puissance,
un deuxième type de commande (II) dans lequel la pompe à chaleur (7) peut être commandée par une consigne de température,
un troisième type de commande (III) dans lequel la pompe à chaleur (7) peut être commandée par une consigne SG-Ready et
un quatrième type de commande (IV) dans lequel la pompe à chaleur (7) peut être commandée par simulation d'un compteur électrique de pompe à chaleur ;
un onduleur (3) pour convertir une tension électrique continue en une tension alternative qui peut être utilisée pour alimenter ladite au moins une unité de consommation électrique (4) et qui peut être convertie en chaleur par ladite au moins une pompe à chaleur (7),
une commande de système (10) avec une mémoire de données (11) dans laquelle est chargé un fichier de configuration de pompe à chaleur (WPK) configurable pour différents types de pompes à chaleur (7), le fichier de configuration de pompe à chaleur (WPK) indiquant au moins un type de commande supporté par la pompe à chaleur (7) et contenant des paramètres de fonctionnement configurables pour paramétrer le type de commande et/ou ladite au moins une pompe à chaleur (7) ;
ladite au moins une pompe à chaleur (7) pouvant être commandée par la commande de système (10) via une interface de commande (12) conformément au fichier de configuration de pompe à chaleur (WPK), et
une communication de la commande de système (10) avec la commande de pompe à chaleur (8) étant effectuée conformément audit au moins un type de commande de la pompe à chaleur (7) indiqué dans le fichier de configuration de pompe à chaleur (WPK).

2. Système énergétique selon la revendication 1,
dans lequel au moins un protocole de communication pour la communication de la commande de système (10) avec la commande de pompe à chaleur (8) est indiqué dans le fichier de configuration de pompe à chaleur (WPK),
dans lequel le protocole de communication indiqué dans le fichier de configuration de pompe à chaleur (WPK) présente un protocole de communication MODBUS, en particulier un protocole de communication MODBUS-TCP ou un protocole de communication MODBUS-RTU.

3. Système énergétique selon la revendication 2,
dans lequel la commande de système (10) communique de manière bidirectionnelle avec la commande de pompe à chaleur (8) via l'interface de commande (12) ou un bus du système énergétique (1) conformément à un protocole de communication indiqué dans le fichier de configuration de pompe à chaleur (WPK).

4. Système énergétique selon la revendication 2 ou la revendication 3,
dans lequel la commande de système (10) est automatiquement configurée en tant que dispositif maître ou en tant que dispositif esclave en fonction du type de commande indiqué dans le fichier de configuration de pompe à chaleur (WPK).

5. Système énergétique selon la revendication 3 ou la revendication 4,
dans lequel le fichier de configuration de pompe à chaleur (WPK) contient une adresse réseau ou IP de la commande de pompe à chaleur (8) pour la communication avec la commande de système (10) du système énergétique (1) conformément aux informations de point de données indiquées dans le fichier de configuration de pompe à chaleur (WPK) de la pompe à chaleur (7),
dans lequel le fichier de configuration de pompe à chaleur (WPK) de la pompe à chaleur (7) présente un fichier JSON, XML, CSV ou TXT.

6. Système énergétique selon l'une des revendications précédentes,
dans lequel la commande de système (10) est intégrée dans l'onduleur (3) du système énergétique (1), ou dans lequel la commande de système (10) est réalisée par une commande de l'onduleur (3) pour former un système de gestion d'énergie.

7. Système énergétique selon la revendication 6,
dans lequel l'interface de commande (12) est formée par une interface MODBUS de l'onduleur (3) et de la pompe à chaleur (7) .

8. Système énergétique selon l'une des revendications précédentes,
dans lequel le système énergétique (1) est raccordé à un réseau d'alimentation électrique (6) via une unité de mesure de courant (5) qui fournit des données de mesure à la commande de système (10) ou à un système de gestion d'énergie du système énergétique (1).

9. Système énergétique selon l'une des revendications précédentes, dans lequel le fichier de configuration de pompe à chaleur (WPK) peut être sélectionné et étendu via une interface utilisateur (13) de la commande de système (10) ou d'un système de gestion d'énergie du système énergétique (1).

10. Système énergétique selon l'une des revendications précédentes,
dans lequel le fichier de configuration de pompe à chaleur (WPK) est chargé par un serveur Web d'une plateforme cloud, via un réseau de données, dans la mémoire de données locale (11) de la commande de système (10) du système énergétique (1), ou dans lequel le fichier de configuration de pompe à chaleur (WPK) est chargé par une unité de lecture de la commande de système (10), à partir d'un support de données, dans la mémoire de données locale (11) de la commande de système (10) du système énergétique (1).

11. Procédé de commande d'une pompe à chaleur (7) comportant les étapes suivantes :
- chargement (S_{A}) d'un fichier de configuration de pompe à chaleur (WPK) pour différents types de pompes à chaleur (7) dans une mémoire de données (11) d'une commande de système (10) d'un système énergétique (1), le fichier de configuration de pompe à chaleur (WPK) indiquant au moins un type de commande supporté par la pompe à chaleur (7) et contenant des paramètres de fonctionnement configurables pour paramétrer le type de commande et/ou la pompe à chaleur (7) ; et
- communication (S_{B}) de la commande de système (10) du système énergétique (1) avec un commande de pompe à chaleur (8) prévu pour la pompe à chaleur (7) conformément au type de commande indiqué dans le fichier de configuration de pompe à chaleur (WPK), intégrant ainsi la pompe à chaleur (7) dans un système de gestion d'énergie du système énergétique (1), la pompe à chaleur (7) supportant un ou plusieurs types de commande parmi un groupe prédéfini de types de commande, et les types de commande comprenant :
un premier type de commande (I) dans lequel la pompe à chaleur (7) est commandée par une consigne de puissance,
un deuxième type de commande (II) dans lequel la pompe à chaleur (7) est commandée par une consigne de température,
un troisième type de commande (III) dans lequel la pompe à chaleur (7) est commandée par une consigne SG-Ready et
un quatrième type de commande (IV) dans lequel la pompe à chaleur (7) est commandée par simulation ou émulation d'un compteur électrique de pompe à chaleur.

12. Procédé selon la revendication 11,
dans lequel, dans le fichier de configuration de pompe à chaleur (WPK) chargé, est en outre indiqué au moins un protocole de communication pour la communication de la commande de système (10) avec la commande de pompe à chaleur (8), et la communication entre la commande de système (10) et la commande de pompe à chaleur (8) s'effectue conformément au protocole de communication indiqué,
dans lequel le protocole de communication présente un protocole de communication MODBUS, en particulier un protocole de communication MODBUS-TCP ou un protocole de communication MODBUS-RTU.

13. Commande de système (10) pour un système énergétique (1) comportant au moins une pompe à chaleur (7), la pompe à chaleur (7) supportant un ou plusieurs types de commande parmi un groupe prédéfini de types de commande, le groupe de types de commande comprenant les types de commande suivants :
un premier type de commande (I) dans lequel la pompe à chaleur (7) peut être commandée par une consigne de puissance,
un deuxième type de commande (II) dans lequel la pompe à chaleur (7) peut être commandée par une consigne de température,
un troisième type de commande (III) dans lequel la pompe à chaleur (7) peut être commandée par une consigne SG-Ready et
un quatrième type de commande (IV) dans lequel la pompe à chaleur (7) peut être commandée par simulation ou émulation d'un compteur électrique de pompe à chaleur, la commande de système (10) comprenant :
une mémoire de données (11) dans laquelle est chargé un fichier de configuration de pompe à chaleur (WPK) pour une pompe à chaleur (7), le fichier de configuration de pompe à chaleur (WPK) étant configurable pour différents types de pompes à chaleur (7), indiquant au moins un type de commande supporté par la pompe à chaleur (7) et contenant des paramètres de fonctionnement configurables pour paramétrer le type de commande et/ou la pompe à chaleur (7) ; et
une interface de commande (12) via laquelle la commande de système (10) communique avec une commande de pompe à chaleur (8) prévue pour la pompe à chaleur (7) conformément au type de commande indiqué dans le fichier de configuration de pompe à chaleur (WPK) chargé pour intégrer la pompe à chaleur (7) dans le système de gestion d'énergie.
